(19) Europäisches Patentamt
European Patent Office
Office européen des brevets

(11) **EP 3 560 594 A1**

(12) **EUROPÄISCHE PATENTANMELDUNG**

(43) Veröffentlichungstag:
**30.10.2019   Patentblatt 2019/44**

(51) Int Cl.:
***B01L 3/00*** *(2006.01)*

(21) Anmeldenummer: **19168017.2**

(22) Anmeldetag: **09.04.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **27.04.2018   DE 102018110210**

(71) Anmelder: **SCHOTT AG**
**55122 Mainz (DE)**

(72) Erfinder:
• **Esemann, Hauke**
**55286 Wörrstadt (DE)**
• **Mangold, Stephanie**
**55270 Klein-Winternheim (DE)**
• **Roters, Andreas**
**55118 Mainz (DE)**
• **Ortner, Andreas**
**55435 Gau-Algesheim (DE)**
• **Heiss-Chouquet, Markus**
**65474 Bischofsheim (DE)**
• **Wagner, Fabian**
**55118 Mainz (DE)**
• **Hiller, Vanessa**
**55130 Mainz (DE)**
• **Brückbauer, Laura**
**67585 Dorn-Dürkheim (DE)**

(74) Vertreter: **Blumbach · Zinngrebe Patentanwälte PartG mbB**
**Alexandrastraße 5**
**65187 Wiesbaden (DE)**

(54) **MIKROFLUIDZELLE UND VERFAHREN ZU DEREN HERSTELLUNG**

(57)     Verfahren zur Herstellung von Mikrofluidik-Zellen (1), bei welchem ein scheibenförmiges Glaselement (3) mit einer Dicke von höchstens 700 Mikrometern so strukturiert wird, dass dieses zumindest eine Öffnung (10) aufweist, welche die beiden gegenüberliegenden parallelen Seitenflächen (30, 31) des Glaselements verbindet, und wobei jede der Seitenflächen (30, 31) des Glaselements (3) mit einem Glasteil (5, 7) verbunden wird, so dass die Öffnung (10) durch die beiden Glasteile (5, 7) verschlossen und eine Mikrofluidik-Zelle (1) mit einem zwischen den beiden Glasteilen (5, 7) eingeschlossenen, für die Führung von Flüssigkeiten geeigneten Hohlraum (9) gebildet wird, wobei das Verbinden des Glaselements (3) mit zumindest einem der beiden Glasteile (5, 7) durch einen vorzugsweise auf die Seitenfläche (30, 31) des Glaselements (3) aufgetragenen Klebstoff (12) erfolgt, wobei beim Auftrag des Klebstoffs (12) die zumindest eine Öffnung (10) im Glaselement (3) ausgespart wird.

Fig. 1

EP 3 560 594 A1

**Beschreibung**

Die Erfindung betrifft allgemein Mikrofluidikzellen, wie sie für verschiedene Aufgaben in der Analytik eingesetzt werden. Im Speziellen betrifft die Erfindung eine Mikrofluidikzelle aus Glas.

Die Mikrofluidikzelle im Sinne eines "Lab on a chip"-Systems ist ein Instrument zur biochemischen bzw. medizinischen Analytik, das immer weitere Verbreitung und Anwendung findet. Durch molekülspezifische Reaktionen zugesetzten Substanzen mit im Innenraum der Mikrofluidikzelle aufgebrachten biologischen Molekülen und Systemen gelingt mittels optischer Sensorik die Identifikation von Moleküle bis hin zur DNA-Sequenzierung.

Die einfachste Darstellung einer Mikrofluidikzelle gelingt durch die Kombination eines mit Kanälen strukturierten Unterteils mit einem Deckel mit Zugängen zu den Kanälen. Im aktuellen Stand der Technik werden diese aus Polymeren, z.B. über das Spritzgussverfahren, hergestellt. Entsprechende Anordnungen sind beispielsweise aus der EP 2 719 460 B1 und der DE 10 2011 085 371 A1 bekannt.

Durch die Herstellung einer Mikrofluidikzelle aus zwei polymeren Bauteilen ergeben sich folgende Nachteile:

- Polymere sind oft nicht resistent gegen verwendete Lösungsmittel oder führen zu unspezifische Reaktionen mit eingebrachten biologischen Molekülen (Biokompatibilität)
- Die Eigenfluoreszenz, als auch die begrenzte Transparenz der Polymere beeinflusst bzw. stört die Auslesequalität bei der Detektierung der fluoreszenzmarkierten Stoffe.
- Die Polymeroberfläche ist zudem nur eingeschränkt einer Funktionalisierung mit Biomarkern zugänglich.

Als Lösungsansatz dazu wurde bereits die Herstellung einer Mikrofluidikzelle aus 3 Bauteilen vorgeschlagen, bei der das untere und obere Bauteil aus Glas bestehen und somit eine hohe Breite an Funktionalisierung erlauben. Zudem wird die Kanalstruktur über ein organisches Polymer- oder Silikonbauteil dargestellt, welches beispielsweise mittels eines schon vor dem Strukturieren aufgebrachten Klebstoffes mit Ober- und Unterteil verbunden wird. Ein Polymerbauteil ist dabei in der EP 2 547 618 B1, Elemente aus Silikon in den Druckschriften JP2013188677 A2 und CN103992948 B beschrieben. Aus der EP 3037826 A1 ist weiterhin eine Mikrofluidikzelle mit einem Sandwich aus einer Elastomerschicht zwischen zwei Glassubstraten bekannt. Die Verbindung erfolgt beispielsweise durch Direktbonden der mittels Korona-Entladung aktivierten Oberflächen. Auch die EP 3088076 A1 beschreibt mehrlagigen Zellen, bei welchen die Kanalstrukturen in Silikon-Lagen eingefügt sind.

Jedoch, hat die Kombination aus dem Glas- und dem Polymermaterial den Nachteil, dass die unterschiedlichen Ausdehnungskoeffizienten der Bauteile bei der Analytik, die verschiedene Temperaturzyklen durchläuft, eine Verformung und im Extremfall eine Undichtigkeit der Zelle zur Folge haben kann. Zudem wird das Problem der Biokompatibilität und der Eigenfluoreszenz mit diesem Ansatz nicht gelöst.

Darüber hinaus besteht bei der Kunststoffzwischenlage das Problem, dass sich durch die mangelnde Steifigkeit des Kunststoffes die oft sehr dünnen und langen Kanalstrukturen beim Zusammenfügen nur mangelhaft auf die Strukturen des Unter- und Oberteils justieren lassen. Da eine kostengünstige Produktion nur durch die Fabrikation große Substrate mit gleichzeitig mehreren Zellen ermöglichen lässt, verstärkt sich das Justageproblem noch.

Möglich wäre es, eine spezielle Mikrofluidikzelle aus drei Glasbauteilen zusammenzusetzen. Dies erfordert allerdings einen zeit- und kostenintensiven Strukturierungsprozess.

Aus der US2008219890 A ist weiterhin eine Mikrofluidikzelle, die aus zwei mit einer Klebeschicht zusammengefügten Bauteilen besteht. Jedoch muss hier ein Bauteil, sobald es aus Glas besteht, teilweise durch einen aufwändigen Photomaskierungs- und Ätzprozess strukturiert werden.

Aus dem Stand der Technik sind verschiedene Strukturierungsprozesse für Glas bekannt. Zum einen können Strukturen in Glas über Ätzprozesse eingebracht werden. Hierfür wird ein vorgeschalteter Maskierungsprozess verwendet, welcher die nicht zu ätzenden Glasteile schützt. Zusätzlich ist es auch möglich Gläser durch präferentielle Ätzung zu modifizieren. Dies ist beispielsweise mit einem unter dem Handelsnamen "Foturan" vertriebenen fotostrukturierbaren Glas der Fall.

Zum anderen werden in den letzten Jahren auch laserbasierte Strukturierungsprozesse eingesetzt. Hierfür sind die Verfahren der Ablation, als auch der Filamentation bekannt.

Wichtige Kriterien bei der Auswahl eines geeigneten Strukturierungsprozesses sind die zur Prozessierung anfallenden Kosten, als auch die Bruchsicherheit des erhaltenen Glasbauteils.

Als Bonding-Verfahren zur Herstellung von Mikrofluidikzellen sind dem Fachmann neben dem Hochtemperatur-Bondingprozess, beispielsweise beschrieben in der US 9446378 B auch das anodische Bonden, Direktbonden (beschrieben beispielsweise in der EP 3088076 A1) und das Laserbonden (wie etwa beschrieben in der US 9517929 B) bekannt. Diese Bondingverfahren haben gemeinsam den Nachteil, dass sie hohe Ansprüche an die zu bondenden Glassubstrate stellen. Diese müssen eine hohe Ebenheit der Oberfläche und geringe Dickentoleranz aufweisen, um eine vollständig geschlossene Kanalstruktur herstellen zu können. Außerdem muss die Oberfläche völlig frei von Partikeln bis in den einstelligen $\mu$m Bereich sein. Diese Herstellungsprozesse erlauben somit keine wirtschaftliche Fertigung in hohen Stückzahlen. Ein weiterer Nachteil, z.B. beim Hochtemperatur-Bonden ist, dass die Zellen erst nach der Fügung mit Biomarkern versehen werden können.

Der Erfindung liegt mithin die Aufgabe zugrunde, eine hinsichtlich der oben dargelegten Nachteile aus dem Stand der Technik verbesserte Mikrofluidikzelle bereitzustellen. Insbesondere soll die Zelle möglichst kunststofffrei und gegenüber bisherigen Zellen aus Glas einfacher herstellbar sein. Diese Aufgabe wird durch den Gegenstand der unabhängigen Ansprüche gelöst. Vorteilhafte Ausgestaltungen der Erfindung sind in den jeweiligen abhängigen Ansprüchen angegeben.

Die Lösung zu den oben genannten Herausforderungen wird nach dieser Erfindung dadurch bewerkstelligt, dass eine Mikrofluidikzelle aus drei Glasbauteilen hergestellt wird, bei denen das mittlere Bauteil (hier auch als Interposer bezeichnet) aus einem strukturierten Dünnglas besteht und mittels eines nach der Strukturierung beidseitig aufgebrachten Klebstoffes an einen Deckel und einen Boden gebondet wird. Hierdurch sind alle drei Bauteile aus einem inerten, nicht fluoreszierenden und gut funktionalisierbaren Werkstoff. Spannungen durch unterschiedlich hohe thermische Ausdehnungen treten nicht auf. Durch die Verwendung von Klebetechnik ist die Dichtigkeit von Zellen leicht zu gewährleisten. Durch das Aufbringen des Klebstoffes auf das strukturierte Bauteil können sowohl der Boden, als auch der Deckel mit ihrer zur Zelle zeigenden Oberfläche kostengünstig, individuell und vollflächig vor dem Zusammenfügen der Bauteile mit Biomarkern versehen werden.

Außerdem erlaubt die Klebetechnik, dass kleine Partikel vom Klebstoff eingeschlossen werden können und so den Bonding-Prozess nicht weiter stören und die Dichtigkeit der Zelle gewährleistet bleibt. Die Anforderungen an die Reinheit der Prozessumgebung sind somit entsprechend geringer.

Das Verfahren gemäß der Erfindung sieht im Speziellen vor, ein scheibenförmiges Glaselement mit einer Dicke von höchstens 700 Mikrometern, vorzugsweise höchstens 500 Mikrometern so zu strukturieren, dass dieses zumindest eine Öffnung aufweist, welche die beiden gegenüberliegenden parallelen Seitenflächen des Glaselements verbindet, und jede der Seitenflächen des Glaselements mit einem Glasteil zu verbinden, so dass die Öffnung durch die beiden Glasteile verschlossen und eine Mikrofluidik-Zelle mit einem zwischen den weiteren Glasteilen eingeschlossener, für die Führung von Flüssigkeiten geeigneter Hohlraum gebildet wird, wobei das Verbinden des Glaselements mit zumindest einem der beiden Glasteile durch einen aufgetragenen Klebstoff erfolgt, wobei beim Auftrag des Klebstoffs die zumindest eine Öffnung im Glaselement ausgespart wird. Der Klebstoff wird vorzugsweise auf die Seitenflächen des Glaselements aufgetragen. Ein strukturierter Auftrag ist aber auch auf die korrespondierenden Flächen der Glasteile möglich.

Bevorzugt werden auch noch dünnere Gläser für das mittlere Glaselement, nämlich mit einer Dicke von höchstens 300 Mikrometern, beispielsweise von 210 Mikrometern oder weniger verwendet. Es können sogar Gläser mit 100 Mikrometern oder dünner, etwa höchstens 70 $\mu$m strukturiert und als Glaselement für die Mikrofluidikzelle eingesetzt werden. Für besonders kleine Strukturen können auch Dünnstgläser mit höchstens 70 $\mu$m, vorzugsweise höchstens 50 $\mu$m oder sogar nur höchstens 30 $\mu$m mit Öffnungen strukturiert werden. Mit diesem Verfahren wird eine Mikrofluidik-Zelle erhalten, die ein scheibenförmiges Glaselement mit einer Dicke von höchstens 700, Mikrometern, vorzugsweise höchstens 300 Mikrometern umfasst, welches so strukturiert ist, dass dieses zumindest eine Öffnung aufweist, welche die beiden gegenüberliegenden parallelen Seitenflächen des Glaselements verbindet, wobei jede der Seitenflächen des Glaselements mit einem Glasteil verbunden ist, so dass die Öffnung durch die beiden Glasteile verschlossen ist und ein zwischen den beiden Glasteilen eingeschlossener, für die Führung von Flüssigkeiten geeigneter Hohlraum vorhanden ist, wobei das Glaselements mit zumindest einem der beiden Glasteile durch eine Klebstoffschicht verbunden ist, wobei die Klebstoffschicht die zumindest eine Öffnung im Glaselement ausspart.

Insbesondere ist in Weiterbildung der Erfindung vorgesehen, dass das Glaselement mit einer Öffnung mit einer langgestreckten Form strukturiert wird, so dass mit dem Verschließen der Öffnung durch die Glasteile ein Hohlraum in Form eines fluidleitenden Kanals geschaffen wird. Für die vorstehend beschriebene Mikrofluidikzelle können verschiedene Strukturierungsverfahren zum Einsatz kommen, um die eine oder mehreren Öffnungen im Glaselement herzustellen. Eine bevorzugte Strukturierung mit einem laserunterstützen Ätzprozess wird weiter unten beschrieben, aber es können durchaus auch andere geeignete Strukturierungsverfahren eingesetzt werden. Eine Herausforderung besteht darin, die zu verklebenden Flächen des ultradünnen, strukturierten Glases (beispielsweise mit einer Dicke von 100 $\mu$m) mit Stegen bis herunter zu einigen hundert Mikrometern Breite und Kanalstrukturen von einigen Zentimetern Länge (1 - 20 cm) ohne Beschädigung (z.B. Haarrisse, Glasbruch) derselben mit einem Klebstoff so zu versehen, dass ausschließlich oder vorwiegend die Bondingflächen, nicht aber die die Kanalwände bildenden Seitenflächen benetzt werden. Dies ist vorteilhaft, da überschüssiger Klebstoff die Reaktionen in der Mikrofluidikzelle stören könnte. Dazu ist in Weiterbildung der Erfindung vorgesehen, den Auftrag des Klebstoffs mittels eines strukturierten Auftragsverfahrens, insbesondere eines Druckverfahrens vorzunehmen, bei welchem der Klebstoff selektiv unter Aussparung eines sich über die Öffnung im Glaselement erstreckenden Bereichs auf die Seitenfläche aufgetragen wird. Als strukturierte Druckverfahren eignen sich insbesondere Tampondruck, Siebdruck, Schablonendruck, Inkjet, oder andere computergesteuerte Jetventile, Rollcoating bzw. Roll-to-Roll-Coating mittels einer strukturierten Rolle, Dispensen, oder Stempelübertrag.

Besonders bevorzugt ist, beide Glasteile mit dem Glaselement zu verkleben. Das Verkleben des Glaselements mit einem der beiden Glasteile kann aber auch mit einem anderen Verbindungsverfahren für das weitere Glasteil kombiniert werden. Beispielsweise könnte eines der Glasteile auch angeschweisst, anodisch gebondet, direkt gebondet oder mit einem Glaslot an das Glaselement gelötet werden.

Generell sind als Klebstoffe oder deren Bestandteil Silikone, Epoxidharze, Acrylate, oder Polyurethane geeignet. Gemäß einer weiteren vorteilhaften Ausführungsform wird ein Haftklebstoff verwendet.

Generell wird es auch bevorzugt, wenn ein fluoreszenzarmer Klebstoff, insbesondere ein Klebstoff ohne Fluoreszenzmarker verwendet wird. Dies erniedrigt Hintergrundsignale bei Fluoreszenzmessungen an der Mikrofluidikzellle.

Um einen Eintrag von Klebstoff in die Öffnung zu vermeiden, ist es besonders vorteilhaft, wenn der Aufdruck des Klebstoffs so erfolgt, dass der ausgesparte Bereich größer als die Öffnung ist, so dass der Rand der aufgetragenen Klebststoffschicht vom Rand der Öffnung beabstandet, insbesondere zurückgesetzt ist.

Allgemein und unabhängig davon, wie der Klebstoffauftrag erfolgt, ist es jedenfalls bevorzugt, dass der Klebstoff so aufgetragen wird, dass die Kante der Öffnung frei von Klebstoff bleibt.

Gemäß einer weiteren Ausführungsform wird eine mit der Aussparung vorstrukturierte Kunststofffolie aufgebracht. Die Kunststofffolie bildet dann die Klebstoffschicht. Insbesondere kann eine solche Kunststofffolie mit einem Haftklebstoff, beziehungsweise einem sogenannten PSA ("Pressure Sensitive Adhesive") versehen sein, um das Glaselement mit dem jeweiligen Glasteil 5 zu verkleben. Gemäß noch einer Ausführungsform wird ein Haftklebstoff auf einem Bahnmaterial in Form eines ablösbaren Träger verwendet. Ein solcher Träger wird auch als "Liner" bezeichnet. Damit kann der Liner mit dem Haftklebstoff auf das Glaselement oder Glasteil aufgebracht und dann abgezogen werden, so dass nur der Haftklebstoff auf dem Glaselement oder Glasteil verbleibt. Der Liner stellt demzufolge ein Bahnmaterial, typischerweise eine Folie mit geringer Haftung am Haftklebstoff dar. Die Verwendung eines Liners ist vorteilhaft, um die Schichtdicke der Verklebung bei Einsatz eines Haftklebstoffes zu verringern.

Weiterhin ist es günstig, wenn die Klebstoffschichtdicke mindestens in der Größenordnung der Dickenschwankung des Glases liegt. Schwankungen in der Klebstoffdicke sollten andererseits aber auf maximal 20 %, bevorzugt maximal 10 % begrenzt werden, so dass die Dichtigkeit gewährleistet werden kann.

Außerdem ist es günstig, das Druckverfahren so auszulegen, dass Fehlstellen in der Klebstoffschicht auf eine Größe unterhalb der minimalen Stegbreite der jeweiligen Struktur, also beispielsweise des minimalen Abstands benachbarter Kanäle beschränkt werden.

Das Verfahren eignet sich besonders in Verbindung mit einem laserbasierten Strukturierungsverfahren zur Herstellung der fluidführenden Strukturen der Zelle. Gemäß einem weiteren Aspekt der Erfindung ist dazu ein Verfahren zur Herstellung von Mikrofluidik-Zellen vorgesehen, bei welchem ein scheibenförmiges Glaselement mit einer Dicke von höchstens 300 Mikrometern so strukturiert wird, dass dieses zumindest eine Öffnung aufweist, welche die beiden gegenüberliegenden parallelen Seitenflächen des Glaselements verbindet, wobei jede der Seitenflächen des Glaselements mit einem Glasteil verbunden wird, so dass die vorzugsweise langgestreckte Öffnung durch die beiden Glasteile verschlossen und eine Mikrofluidik-Zelle mit einem zwischen den beiden Glasteilen eingeschlossenen, für die Führung von Flüssigkeiten geeigneten Hohlraum gebildet wird, wobei die Öffnung im Glaselement erzeugt wird, indem - der Laserstrahl eines Ultrakurzpulslasers auf eine der Seitenflächen des Glaselements gerichtet und mit einer Fokussierungsoptik zu einem langgezogenen Fokus im Glaselement konzentriert wird, wobei durch die eingestrahlte Energie des Laserstrahls eine filamentförmige Schädigung im Volumen des Glaselements erzeugt wird, deren Längsrichtung quer zur Seitenfläche, insbesondere senkrecht zur Seitenfläche verläuft und zur Erzeugung einer filamentförmigen Schädigung der Ultrakurzpulslaser einen Puls oder ein Pulspaket mit mindestens zwei aufeinander folgenden Laserpulsen einstrahlt, und wobei nach dem Einfügen der filamentförmigen Schädigung das Glaselement einem Ätzmedium ausgesetzt wird, welches Glas des Glaselements mit einer Abtragsrate von vorzugsweise kleiner als 8 $\mu$m pro Stunde abträgt und die filamentförmige Schädigung zu einem Kanal aufweitet. Typischerweise fügt das Ätzverfahren in der Wandung des Kanals abgerundete, kalottenförmige Vertiefungen ein. Das Verbinden des scheibenförmigen Glaselements mit den beiden Glasteilen kann wie oben beschrieben durch Verkleben, insbesondere mit einem strukturierten Klebstoffauftrag erfolgen. Denkbar sind aber generell auch andere Verbindungsverfahren, wie etwa anodisches Bonden, Direktbonden oder Laserverschweißen.

Mit dem vorstehend beschriebenen Verfahren können auch größere Öffnungen, insbesondere auch langgestreckte Öffnungen zur Herstellung von Kanälen erzeugt werden. Dazu ist in Weiterbildung der Erfindung vorgesehen, dass nebeneinander eine Vielzahl von filamentförmigen Schädigungen eingefügt und durch das Ätzen der Durchmesser der Kanäle so weit vergrößert wird, bis das Glas zwischen den Kanälen abgetragen wird und die Kanäle sich vereinigen.

Die Erfindung wird nachfolgend genauer und unter Bezugnahme auf die beigeschlossenen Zeichnungen erläutert.


Kurzbeschreibung der Figuren

Fig. 1          ist eine Explosionsdarstellung einer Mikrofluidikzelle.

Fig. 2          ist eine Schnittdarstellung der Elemente einer Mikrofluidikzelle.

Fig. 3          zeigt die Elemente gemäß Fig. 2 in zusammengefügter Form.

Fig. 4          zeigt eine Anordnung zum Auftrag des Klebstoffs.

Fig. 5          zeigt eine Vorrichtung zur Laserbearbeitung eines Glaselements als Vorbereitung zum Einfügen einer Öffnung.

Fig. 6          zeigt ein Glaselement mit eingefügten filamentförmigen Schädigungen.

Fig. 7          zeigt das Glaselement mit entlang der filamentförmigen Schädigungen eingefügten Kanälen.

Fig. 8          stellt das Glaselement 3 aus Fig. 7 nach dem Herauslösen eines Teils dar.

Fig. 9          zeigt eine Variante des Glaselements aus Fig. 7.

Fig. 10 und Fig. 11          sind elektronenmikroskopische Aufnahmen einer Kante eines Glaselements in unterschiedlicher Vergrößerung.

Fig. 12 und Fig. 13          zeigen elektronenmikroskopische Aufnahmen von Kanälen in einem anderen Glas, die mit verschiedenen Laserparametern eingefügt wurden.

Fig. 14 und Fig. 15          sind elektronenmikroskopische Aufnahmen einer Kante eines Glaselements in unterschiedlicher Vergrößerung.

Fig. 16          zeigt einen Teil eines Glaselements mit einem Steg zwischen zwei Öffnungen.

Fig. 17          zeigt ein Glaselement mit von Stegen gehaltenen Strukturen.

Fig. 18          stellt eine Mikrofluidikzelle mit einer Mehrlagenstruktur dar.

Fig. 19          zeigt eine Variante der Erfindung mit einer Ausnehmung, die zwei Hohlräume verbindet.

Fig. 20          zeigt eine weitere Variante mit einer Ausnehmung im Glaselement.

Fig. 21          stellt ein Glaselement mit filamentförmigen Schädigungen dar.

Fig. 22          zeigt ein Glaselement mit einem Muster von filamentförmigen Schädigungen in Aufsicht.

Fig. 23          zeigt eine Anordnung zum Einfügen von filamentförmigen Schädigungen in ein Glaselement.

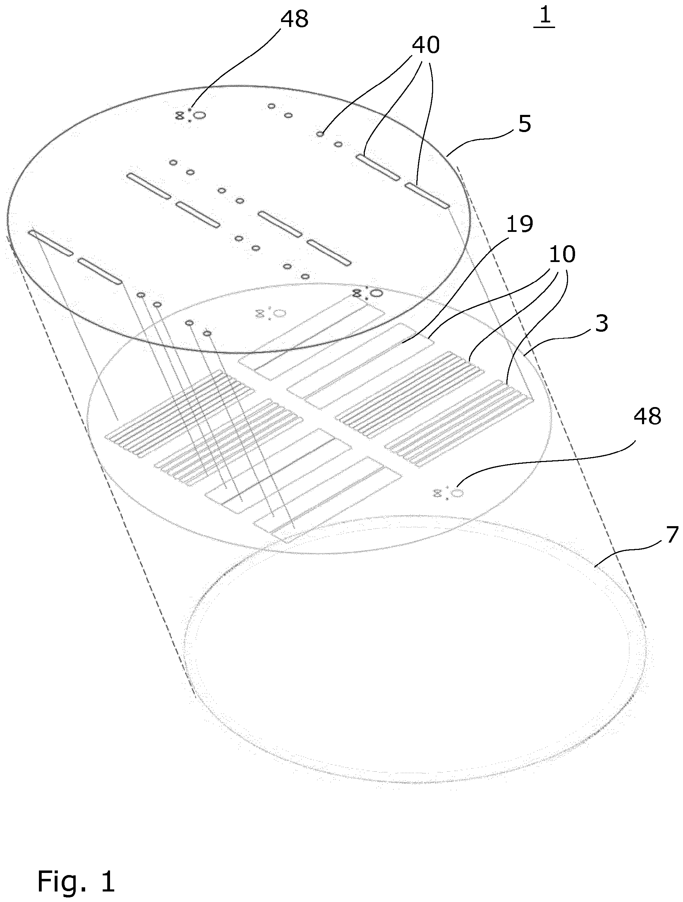

Fig. 1 zeigt eine Explosionszeichnung einer Mikrofluidik-Zelle 1, wie sie mit der Erfindung herstellbar ist. Die Mikrofluidik-Zelle 1 umfasst ein scheibenförmiges Glaselement 3, dessen Seitenflächen mit zwei Glasteilen 5, 7, die typischerweise ebenfalls scheibenförmig sind, verbunden werden. Ohne Beschränkung auf das dargestellte Beispiel ist gemäß einer Ausführungsform der Erfindung vorgesehen, dass die Glasteile 5, 7 den Boden und den Deckel der Mikrofluidikzelle 1 bilden. In der Explosionszeichnung sind zur Verdeutlichung der Strukturierung der Teile das scheibenförmige Glaselement 3 und die Glasteile 5, 7 getrennt voneinander dargestellt.

Wie in der Darstellung zu erkennen, weist das scheibenförmige Glaselement 3 eine Vielzahl von nebeneinander liegenden langgestreckten Öffnungen 10 auf. Diese sind teilweise durch schmale Stege 19 voneinander getrennt. Werden die Glasteile 5, 7 mit dem scheibenförmigen Glaselement 3 verbunden, so werden die langgestreckten Öffnungen 10 durch die beiden Glasteile 5, 7 verschlossen und Hohlräume gebildet, die insbesondere entsprechend der Form der Öffnungen 10 in Richtung entlang der Seitenflächen des Glaselements 3 verlaufende langgestreckte Kanäle bilden.

Auch sehr dünne Stege 19 lassen sich mit dem Klebstoff bedrucken. In einer Ausführungsform der Erfindung ist vorgesehen, dass ein Glaselement 3 mit zumindest zwei nebeneinander verlaufenden Öffnungen 10 bereitgestellt wird, die durch einen Steg 19 voneinander getrennt sind, der eine minimale Breite von höchstens 400 $\mu$m aufweist, wobei der Steg des Glaselements 3 mit Klebstoff mit dem Glasteil 5, beziehungsweise 7 verbunden wird. Im dargestellten Beispiel ist eine Gruppe von Öffnungen 10 hergestellt worden, die durch Stege 19 mit einer Stegbreite von 300 $\mu$m getrennt sind. Um noch eine dichtende Verbindung zu gewährleisten und einen Eintrag von Klebstoff auf die Wandung des aus der Öffnung gebildeten Hohlraumes zu vermeiden oder mindestens zu reduzieren, wird eine minimale Breite des Stegs von mindestens 50 $\mu$m bevorzugt.

Um die Glasteile 5, 7 mit dem scheibenförmigen Glaselement 3 zu verbinden, ist nun vorgesehen, dass auf die zu verbindenden Flächen Klebstoff aufgetragen wird. Vorzugsweise erfolgt der Klebstoffauftrag zumindest für die Verbindung mit einem der Glasteile 5, 7 auf dem scheibenförmigen Glaselement 3. Der Klebstoffauftrag kann aber auch auf eine korrespondierende Fläche des zu verbindenden Glasteils 5, beziehungsweise 7 erfolgen.

Wie weiter anhand von Fig. 1 zu erkennen ist, weist zumindest eines der Glasteile 5, 7 eine Öffnung 40 auf. Typischerweise werden wie im dargestellten Beispiel und abhängig vom Design der Mikrofluidikzelle 1 mehrere solcher Öffnungen 40 vorhanden sein. Die Öffnungen 40 dienen als Einfüllöffnungen für Fluide und korrespondieren daher mit jeweils mindestens einer Öffnung 10 im Glaselement 3.

In einer Weiterbildung der Erfindung, ohne Beschränkung auf das dargestellte Beispiel ist daher vorgesehen, dass in zumindest eines der Glasteile eine Öffnung 40 vorhanden ist oder in das Glasteil 5, 7 eingefügt wird, wobei das Glasteil 5, 7 so mit dem Glaselement zusammengeführt wird, dass die Öffnung 40 eine Verbindung zur Öffnung 10 im Glaselement 3 und damit eine fluidleitende Verbindung in den beim Verschließen mit den beiden Glasteilen 5, 7 aus der Öffnung 10 im Glaselement 3 erzeugten Hohlraum herstellt. Beispielsweise kann der durch die Öffnung 10 in langgestreckter Form einen Hohlraum 9 in Form eines dünnen Kanals bilden, in welchem eine an der Öffnung 40 im Glasteil 5, 7 bereitgestellte Flüssigkeit entlanggeleitet wird. In einem Ausführungsbeispiel wurde ein Interposer mit einer Dicke von 80 Mikrometern als Glaselement 3 mit einem Glaselement 5 mit einer Dicke von 0,7 Millimetern als Deckel und einem Glaselement 7 als Boden mit einer Dicke von 0,3 Millimetern verklebt.

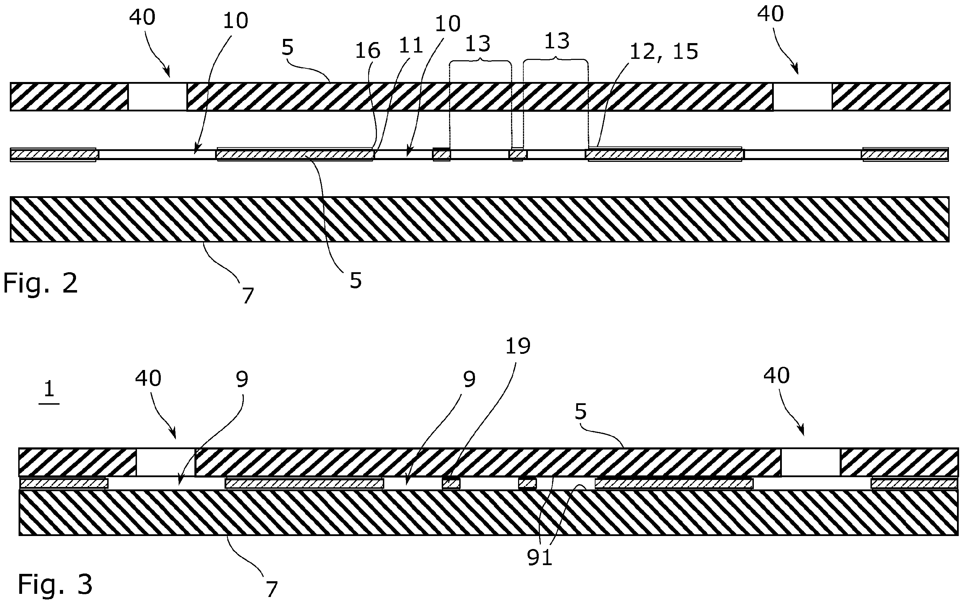

Fig. 2 zeigt als Schnittdarstellung die Teile der Mikrofluidikzelle, nämlich das Glaselement 3 und die Glasteile 5, 7, welche Deckel und Boden der Zelle bilden, vor dem Zusammenfügen. Fig. 3 zeigt die Elemente gemäß Fig. 2 in zusammengefügter Form, also die mit den Glasteilen 5, 7 und dem Glaselement 3 gebildeten Mikrofluidikzelle 1.

Das Verbinden des Glaselements 3 mit den beiden Glasteilen 5, 7 erfolgt durch einen aufgetragenen Klebstoff 12. Beim Auftrag des Klebstoffs 12 werden die Öffnungen 10 im Glaselement 3 ausgespart. Damit wird vermieden, dass der Klebstoff an die Ränder 11 der Öffnungen 10 gerät und sich dadurch nach Fertigstellung der Zelle in den aus den Öffnungen gebildeten Hohlräumen 9 befindet. Der Klebstoff 12 wird als dünne Klebstoffschicht 15 aufgebracht. Bei dem dargestellten Beispiel erfolgt der Auftrag beidseitig auf das Glaselement 3. Es ist aber auch denkbar, den Klebstoff einer oder beider Verbindungen auf ein Glasteil 5, 7 aufzutragen. Jedenfalls wird der Klebstoff aber insbesondere so aufgetragen, dass die Kante der Öffnung 10, welche später die Seitenwandung eines mit der Öffnung 10 erzeugten Hohlraumes bildet, frei von Klebstoff bleibt.

Die Klebstoffschicht 15 kann auch als klebende Folie aufgebracht werden, beispielsweise als mit einem Haftkleber versehene Folie.

Generell kann es wünschenswert sein, das Glaselement 3 mit den Klebstoffschichten 15 vorzufertigen und erst zu einem späteren Zeitpunkt die Glasteile 5, 7 anzufügen. Dies ist beispielsweise dann der Fall, wenn etwa eines oder beide der Glasteile 5, 7 mit Biomarkern oder allgemein biofunktionellen Molekülen versehen werden, die dann nach dem Verbinden an der Wandung des Hohlraums 9 haften und mit Bestandteilen eines eingefüllten Fluids reagieren können. Damit wird also allgemein eine Mikrofluidikzelle 1 geschaffen, bei welcher das Glaselement 3 mit zumindest einem der Glasteile 5, 7 durch eine Klebstoffschicht 15 verbunden ist, wobei die Klebstoffschicht 15 einen ausgesparten Bereich 13 um die zumindest eine Öffnung 10 aufweist, so dass der durch das Glasteil 5, 7 gebildete Teil der Wandung des Hohlraums 9 von der Klebstoffschicht 15 ausgespart ist, und wobei zumindest dieser Teil der Wandung des Hohlraums 9 mit anhaftenden biofunktionellen Molekülen, insbesondere Biomarkern versehen ist. Werden die biofunktionellen Moleküle vollflächig aufgetragen, befinden diese sich dann auch im verklebten Bereich, wo diese dann aber natürlich nicht mit dem zu behandelnden Fluid in Kontakt kommen können.

Um beispielsweise eine solche spätere Verklebung mit individuell ausgestatteten Glasteilen 5, 7 vornehmen zu können, betrifft die Erfindung auch ein Zwischenprodukt zur Herstellung einer Mikrofluidikzelle 1 mit einem scheibenförmigen Glaselement 3 mit einer Dicke von höchstens 700 Mikrometern, welches so strukturiert ist, dass dieses zumindest eine Öffnung 10 aufweist, welche die beiden gegenüberliegenden parallelen Seitenflächen 30, 31 des Glaselements 3 verbindet, wobei jede der beiden Seitenflächen 30, 31 mit einer Klebstoffschicht 15 versehen ist, um die Seitenflächen 30, 31 mit Glasteilen 5, 7 zu verbinden, so dass die Öffnung 10 verschlossen und eine Mikrofluidikzelle 1 mit einem für die Führung von Flüssigkeiten geeigneten Hohlraum 9 gebildet wird, wobei die Klebstoffschicht 15 die zumindest eine Öffnung 10 im Glaselement 3 ausspart.

Wie anhand von Fig. 2 zu erkennen ist, kann der Aufdruck des Klebstoffs 12 so erfolgen, dass ausgesparte Bereiche 13 größer als die korrespondierenden Öffnungen 10 sind, so dass der Rand 16 der aufgetragenen Klebstoffschicht 15 vom Rand 11 der jeweiligen Öffnung 10 beabstandet, insbesondere zurückgesetzt ist. Damit wird vermieden, dass der Klebstoff unter Druck so weit seitlich ausweicht, dass dieser in die Öffnung 10 gerät.

Allgemein werden dünne Klebstoffschichten 15 bevorzugt. Gemäß einer Ausführungsform der Erfindung wird bevorzugt, dass der Klebstoff 12 mit einer Dicke von höchstens 50 $\mu$m, bevorzugt höchstens 20 $\mu$m appliziert wird. Wie oben erwähnt, ist es günstig, wenn die Klebstoffschichtdicke aber mindestens in der Größenordnung der Dickenschwankung des Glases liegt. Allgemein wird bevorzugt, dass die Dicke der aufgetragenen Klebstoffschicht mindestens 2 $\mu$m beträgt.

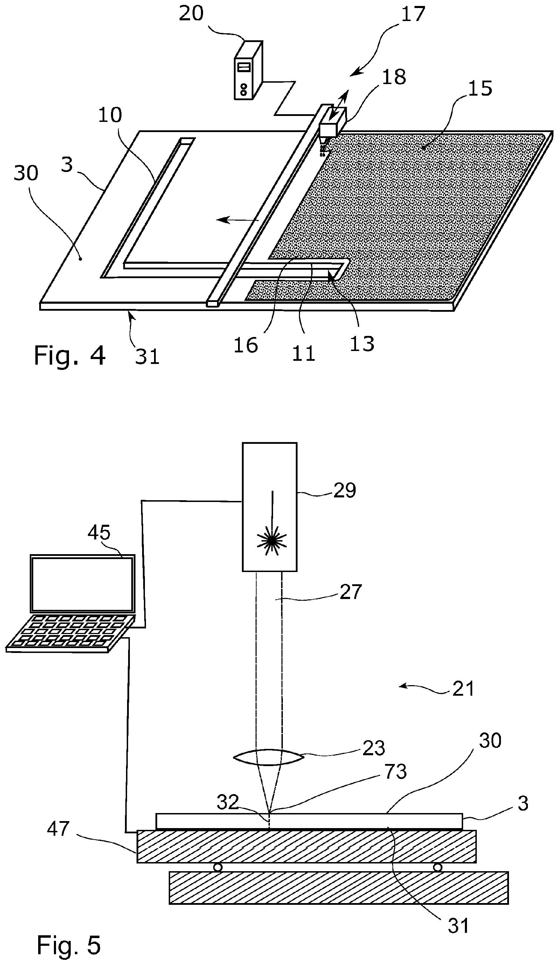

Fig. 4 zeigt eine Anordnung, um die Klebstoffschicht 15 auf das Glaselement 3 oder eines der Glasteile 5, 7 aufzubringen. Der Auftrag des Klebstoffs 12 erfolgt mittels eines strukturierten Druckverfahrens, bei welchem der Klebstoff selektiv unter Aussparung eines sich über die Öffnung 10 im Glaselement 3 erstreckenden Bereichs 13 auf die jeweilige Seitenfläche 30, 31 des Glaselements aufgetragen wird. Gemäß einer Ausführungsform der Erfindung wird dazu eine Druckvorrichtung 17 mit einem von einem Rechner 20 angesteuerten Druckkopf 18 verwendet. Der Druckkopf kann insbesondere ein Tintenstrahl-Druckkopf sein, der über das Glaselement 3 bewegt wird, während dieser den Klebstoff tröpfchenweise abgibt. Der Rechner steuert den Druckkopf so an, dass der Bereich 13, in dem die langgestreckte Öffnung 10 liegt, ausgespart wird. Beispielsweise kann der Druckkopf mäanderförmig über das Glaselement 3 bewegt werden, wobei der Druckkopf an einer Traverse hin und her bewegt und die Traverse oder alternativ das Glaselement 3 zeilenweise vorgeschoben wird.

Wie dargestellt, kann der Bereich 13 größer als die Öffnung 10 gehalten werden, so dass der Rand des ausgesparten Bereiches etwas zum Rand 11 der Öffnung 10 beabstandet ist. Es können neben der Ausführungsform mit einem Ink-Jet-Druckkopf auch andere Verfahren zum Einsatz kommen. Weitere Druckverfahren sind Tampondruck, Siebdruck, Schablonendruck, Rollcoating, beziehungsweise Roll-to-Roll-Coating, Dispensen, Stempelübertrag. Besonders für größere Stückzahlen eignen sich Druckverfahren wie Tampondruck und Siebdruck. In einem Ausführungsbeispiel wurde für die Herstellung eines wie in Fig. 1 gezeigten Aufbaus einer Mikrofluidikzelle mit Siebdruck ein Acrylat-Klebstoff mit einer Viskosität von 9600 mPa·s beidseitig auf das Glaselement 3 aufgetragen. Mit den Positionierungsmarkem 48 können nicht nur das Glaselement 3 zum Glasteile 5, sondern auch die Siebdruckmaske zur Struktur der Mikrofluidikzelle ausgerichtet werden.

Die Viskosität des Klebstoffs kann allgemein auch an das Druckverfahren angepasst sein. So werden für Tampondruck niedrigere Viskositäten, beispielsweise im Bereich um 300 mPa·s bevorzugt. Bei dem in Fig. 4 dargestellten beispielhaften Tintenstrahl-Verfahren werden noch niedrigere Viskositäten, vorzugsweise unterhalb von 50 mPa·s bevorzugt.

Eine bevorzugte Ausführungsform der Erfindung sieht vor, einen lichthärtenden, bevorzugt UV-härtenden Klebstoff 12 aufzutragen. Dann kann der Klebstoff 12 durch eines der Glasteile 5, 7 hindurch mit Licht, vorzugsweise UV-Licht bestrahlt werden, so dass der Klebstoff aushärtet und das Glasteil, beziehungsweise bei beidseitigem Auftrag beide Glasteile 5, 7 fest mit dem Glaselement 3 verklebt. Geeignete Klebstoffe, die auch UV-härtend sein können, sind sililkonhaltige Klebstoffe, Epoxidharze, Acrylate.

Nachfolgend wird eine bevorzugte Ausführungsform der Strukturierung des Glaselements 3 beschrieben, um eine oder mehrere langgestreckte Öffnungen 10 einzufügen. Die Öffnung 10 im Glaselement 3 wird erzeugt, indem

- der Laserstrahl 27 eines Ultrakurzpulslasers 29 auf eine der Seitenflächen 30, 31 des Glaselements 3 gerichtet und mit einer Fokussierungsoptik 23 zu einem langgezogenen Fokus im Glaselement 3 konzentriert wird, wobei durch die eingestrahlte Energie des Laserstrahls 27 eine filamentförmige Schädigung 32 im Volumen des Glaselements 1 erzeugt wird, deren Längsrichtung quer zur Seitenfläche 30, 31, insbesondere senkrecht zur Seitenfläche 30, 31 verläuft und zur Erzeugung einer filamentförmigen Schädigung der Ultrakurzpulslaser 29 einen Puls oder ein Pulspaket mit mindestens zwei aufeinander folgenden Laserpulsen einstrahlt, und wobei nach dem Einfügen der filamentförmigen Schädigung 32
- das Glaselement 3 einem Ätzmedium ausgesetzt wird, welches Glas des Glaselements 3 mit einer Abtragsrate von vorzugsweise kleiner als 8 $\mu$m pro Stunde abträgt und
- die filamentförmige Schädigung 32 zu einem Kanal 35 aufweitet und
- in der Wandung des Kanals abgerundete, kalottenförmige Vertiefungen einfügt.

In Fig. 5 ist ein Ausführungsbeispiel für eine Laserbearbeitungsvorrichtung 20 gezeigt, mit welcher in ein Glaselement 1 filamentförmige Schädigungen 32 eingefügt werden können, um nachfolgend in einem Ätzprozess Kanäle an den Stellen der filamentförmigen Schädigungen 32 einzufügen. Die Vorrichtung 21 umfasst einen Ultrakurzpulslaser 30 mit vorgeschalteter Fokussierungsoptik 23 und eine Positioniereinrichtung 47. Mit der Positioniereinrichtung 47 kann der Auftreffpunkt 73 des Laserstrahls 27 des Ultrakurzpulslasers 30 auf der Seitenfläche 2 eines zu bearbeitenden plattenförmigen Glaselements 1 lateral positioniert werden. Bei dem dargestellten Beispiel umfasst die Positioniereinrichtung 17 einen x-y-Tisch, auf dem das Glaselement 1 auf einer Seitenfläche 3 aufliegt. Alternativ oder zusätzlich möglich ist aber auch, die Optik beweglich auszubilden, um den Laserstrahl 27 zu bewegen, so dass der Auftreffpunkt 32 des Laserstrahls 27 bei festgehaltenem Glaselement 1 bewegbar ist.

Die Fokussierungsoptik 23 fokussiert den Laserstrahl 27 nun zu einem in Strahlrichtung, also dementsprechend quer, insbesondere senkrecht zur bestrahlten Seitenfläche 2 langgezogenen Fokus. Ein solcher Fokus kann beispielsweise mit einer kegelförmigen Linse (ein sogenanntes Axikon) oder einer Linse mit großer sphärischer Aberration erzeugt werden. Die Steuerung der Positioniereinrichtung 17 und des Ultrakurzpulslasers 30 wird vorzugsweise mittels einer programmtechnisch eingerichteten Recheneinrichtung 15 durchgeführt. Auf diese Weise lassen sich vorbestimmte Muster von lateral entlang der Seitenfläche 2 verteilten filamentförmigen Schädigungen 32 erzeugen, dies insbesondere durch Einlesen von Positionsdaten, vorzugsweise aus einer Datei oder über ein Netzwerk.

Gemäß einem Ausführungsbeispiel können folgende Parameter für den Laserstrahl verwendet werden: Die Wellenlänge des Laserstrahls beträgt 1064nm, typisch für einen YAG-Laser. Es wird ein Laserstrahl mit einem Rohstrahldurchmesser von 12mm erzeugt, der dann mit einer Optik in Form einer Bikonvex-Linse mit einer Brennweite von 16mm fokussiert wird. Die Pulsdauer des Ultrakurzpulslasers beträgt weniger als 20ps, bevorzugt etwa 10ps. Die Pulse werden in Bursts mit 2 oder mehr, bevorzugt 4 oder mehr Pulsen abgegeben. Die Burstfrequenz beträgt 12-48ns, bevorzugt etwa 20ns, die Pulsenergie mindestens 200 Mikrojoule, die Burstenergie entsprechend mindestens 400 Mikrojoule.

Anschließend, nach dem Einfügen einer oder insbesondere einer Vielzahl von filamentförmigen Schädigungen 32 wird das Glaselement 1 entnommen und in einem Ätzbad gelagert, wo in einem langsamen Ätzprozess Glas entlang der filamentförmigen Schädigungen 32 entfernt wird, so dass an der Stelle einer solchen Schädigung 32 jeweils ein Kanal in das Glaselement 1 eingefügt wird.

Bevorzugt wird ohne Beschränkung auf spezielle Ausführungsbeispiele allgemein ein basisches Ätzbad, vorzugsweise mit einem ph-Wert >12, beispielsweise eine KOH-Lösung mit >4mol/l bevorzugt >5mol/l besonders bevorzugt >6mol/l, aber <30mol/l. Das Ätzen wird gemäß einer Ausführungsform der Erfindung unabhängig vom verwendeten Ätzmedium bei einer Temperatur des Ätzbads von >70°C, bevorzugt >80°C, besonders bevorzugt >90°C durchgeführt. Das Ätzen mit einem basischen Ätzbad führt zu der Struktur mit kalottenförmigen Vertiefungen. Möglich ist aber auch ein Ätzen mit einem sauren Ätzmedium.

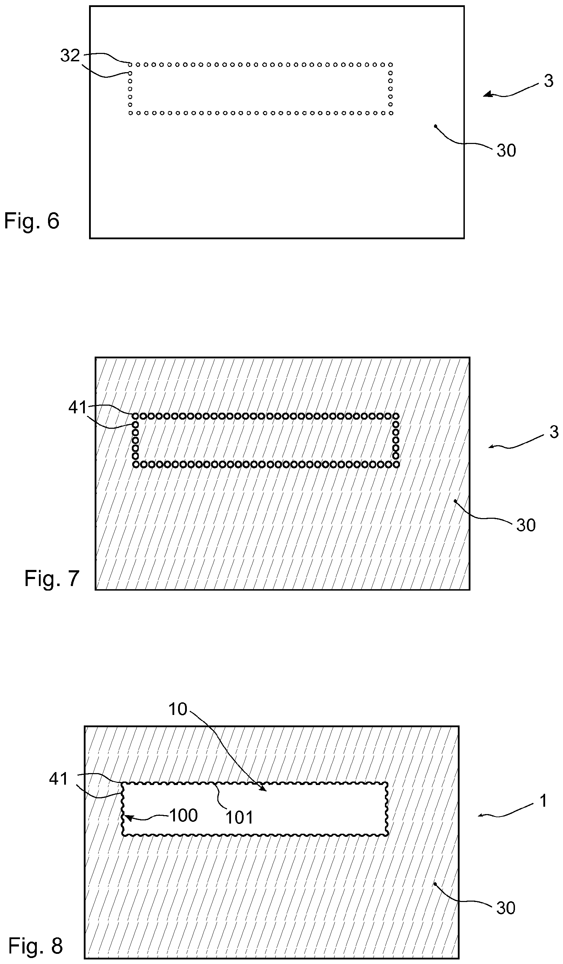

Fig. 6 zeigt in Aufsicht auf eine Seitenfläche 30 ein Glaselement 1 mit einer Vielzahl von filamentförmigen Schädigungen 32, die in einem bestimmten Muster angeordnet sind, wie es durch die oben beschriebene rechnergesteuerte Ansteuerung der Positioniereinrichtung 17 und des Ultrakurzpulslasers 29 in das Glaselement 1 eingeschrieben werden kann. Im Speziellen sind die filamentförmigen Schädigungen 32 hier beispielhaft entlang eines vorgegebenen Pfades in Form einer geschlossenen rechteckigen Linie in das Glaselement 1 eingefügt worden. Die Ecken der Linie können auch leicht abgerundet sein. Es ist dem Fachmann ersichtlich, dass mit dem Verfahren nicht nur rechteckige, sondern beliebig geformte Pfade abgefahren werden können. Die Anordnung der filamentförmigen Linien entspricht dem Umriss einer in das Glaselement einzufügenden langgestreckten Öffnung.

Fig. 7 zeigt das Glaselement 3 nach einem nachfolgenden Ätzschritt. An Stelle der filamentförmigen Schädigungen 32 sind nun Kanäle 41 vorhanden, die entlang des vorgegebenen Pfades nebeneinander angeordnet und aufgereiht sind. Das Glaselement 3 ist schraffiert dargestellt, um das Element von Öffnungen, wie sie auch die Kanäle 41 darstellen, zeichnerisch zu unterscheiden.

Die eingefügten, nebeneinander entlang des vom Laser abgefahrenen Pfads aufgereihten Kanäle 41 können nun als Sollbruchstellen dienen, um ein Teil des Glaselements 3 herauszulösen, beziehungsweise das Glaselement 1 entlang dieses Pfads aufzutrennen, um eine Öffnung 10 zu erhalten.

Fig. 8 zeigt das Glaselement 3 nach dem Auftrennen entlang des Pfads. Da die Kanäle 41 entlang geschlossenen, hier beispielhaft rechteckigen Trennlinie angeordnet waren, wird durch das Abtrennen ein Innenteil abgelöst und eine Öffnung 10 im Glaselement 3 geschaffen.

Ganz allgemein, ohne Beschränkung auf das spezielle Ausführungsbeispiel wird mit einem Abtrennen entlang einer durch einen oder mehrere Kanäle 41 nun ein plattenförmiges Glaselement 3 mit einem Kanal 41 erhalten, der seitlich offen ist und einen Teil der Kante 100, der Öffnung 10 bildet.

Weiterhin war, wie in Fig. 7 gezeigt, zwischen den Kanälen 41 noch Glasmaterial vorhanden. Demgemäß waren Innenteil und umgebendes Glaselement 3 nach dem Ätzen noch miteinander verbunden. Das endgültige Abtrennen kann dann beispielsweise durch Brechen erfolgen. Aufgrund der durch die nebeneinander angeordneten Kanäle 41 geschaffenen Perforation bricht das Glaselement 3 entlang des Pfades der aufgereihten Kanäle 41. Allgemein, ohne Beschränkung auf das dargestellte Beispiel wird auf diese Weise eine Kante 100 erzeugt, bei welcher sich wie in Fig. 8 dargestellt zwischen den Kanälen 41 ebene Kantenabschnitte 101 erstrecken. Die ebenen Kantenabschnitte 11 bilden sich dabei beim Bruch des Glases zwischen den Kanälen 41 aus.

Um ein Innenteil herauszulösen und/oder eine Öffnung 10 in einem Glaselement 3 zu erzeugen, eignet sich eine Variante des vorstehend beschriebenen Verfahrens besonders. Diese Ausführungsform der Erfindung basiert darauf, dass durch das Ätzen der Durchmesser der Kanäle 41 so weit vergrößert wird, bis das Glas zwischen den Kanälen 41 abgetragen wird und die Kanäle 41 sich vereinigen.

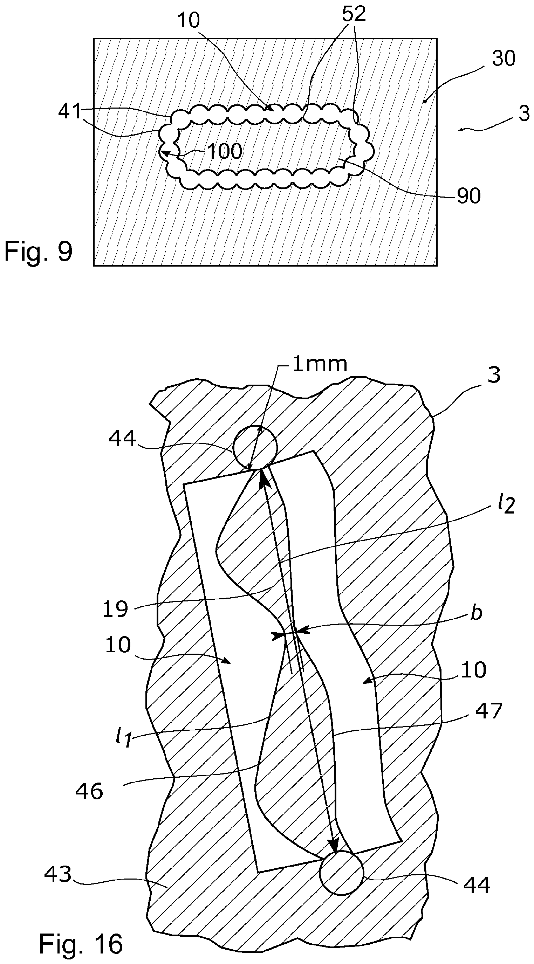

Ein Glaselement 3, bei welchem die Kanäle 41 sich beim Ätzen seitlich vereinigt haben, zeigt Fig. 9. Wie bei dem Beispiel der Fig. 8 sind die Kanäle 41 entlang eines geschlossenen Pfades nebeneinander aufgereiht. Dementsprechend wird mit dem Ablösen wiederum eine Öffnung 10 und ein komplementäres Innenteil erzeugt. In dem dargestellten Beispiel ist das Innenteil 90 zwar schon abgetrennt, aber noch in der Öffnung 10 angeordnet.

Die Fig. 6 bis Fig. 9 sind Beispiele einer Ausführungsform der Erfindung, gemäß welcher eine Kante 10 des Glaselements 1 geschaffen wird, die eine Vielzahl von parallel nebeneinander verlaufenden, seitlich offenen Kanälen 5 aufweist.

Weiterhin liegt allen diesen Beispielen eine Ausführungsform des erfindungsgemäßen Verfahrens zugrunde, bei welchem

- der Auftreffpunkt 73 des Laserstrahls 27 auf dem Glaselement 3 entlang eines vorgegebenen Pfades geführt und
- eine Vielzahl von nebeneinander auf dem Pfad liegenden filamentförmigen Schädigungen 32 und
- anschließend durch das Ätzen eine Vielzahl von nebeneinander liegenden Kanälen 5 in das Glaselement 1 eingefügt wird, und
- das Glaselement 3 dann entlang des Pfades aufgetrennt wird, so dass eine Kante 100 mit seitlich geöffneten Kanälen 41 gebildet wird.

Die Kanäle 41 weisen im Allgemeinen eine rohrförmig zylindrische Grundform auf, beziehungsweise sind rohrförmig mit zylindrisch geformter Wandung. Dabei kann eine leichte Verjüngung von der Öffnung an der Seitenfläche zur Mitte des Glaselements 1 hin vorhanden sein. Bei der Vereinigung der allgemein zylindrisch geformten Kanäle 5 im Zuge des Aufweitens während des Ätzvorgangs können sich Grate an den Stoßstellen bilden. Allgemein, ohne Beschränkung auf das Beispiel der Fig. 9 ist nach einer Ausführungsform der Erfindung vorgesehen, dass die Kanäle 41 aneinander angrenzen, so dass zwischen den Kanälen 41 Grate 52 gebildet werden, die parallel zur Längsrichtung der Kanäle 5 verlaufen.

Diese Grate oder Rippen verlaufen dementsprechend parallel zur Längsrichtung der Kanäle und sind in der Darstellung der Fig. 5 daher nur als zacken- oder zahnförmige Elemente an der Stelle des Übergangsbereichs benachbarter Kanäle 5 zu sehen.

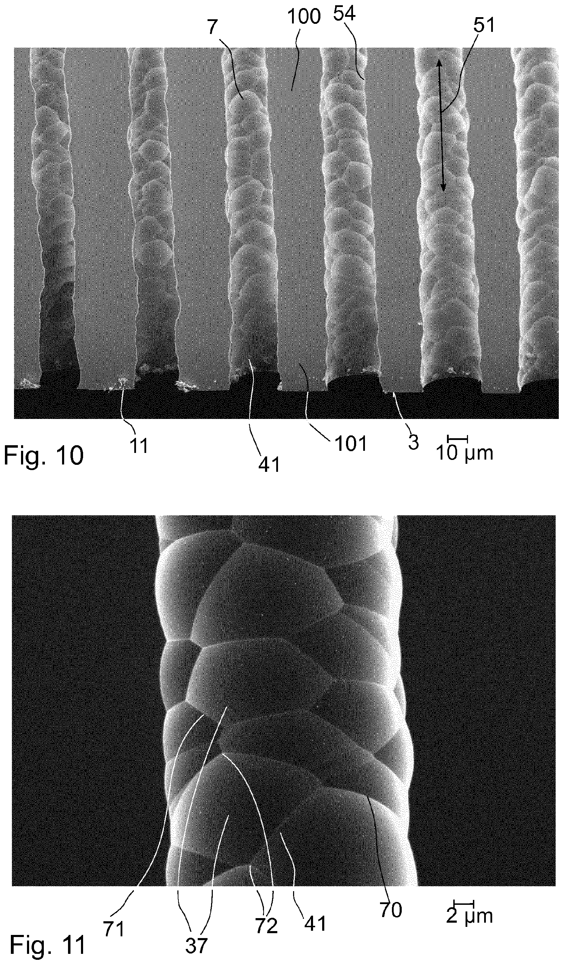

Fig. 10 und Fig. 11 zeigen elektronenmikroskopische Aufnahmen der Kante 100 eines erfindungsgemäß bearbeiteten Glaselements 3. Dabei wurde Fig. 11 mit einer größeren Vergrößerung aufgenommen. Wie bei den Beispielen der Fig. 8 und Fig. 9 weist die Kante 100 eine Vielzahl von parallel nebeneinander verlaufenden, seitlich offenen Kanälen 41 auf. In der Darstellung der Fig. 10 in Aufsicht auf die Kante 100 ist nun ersichtlich, dass sich die Längsrichtung 51 quer, insbesondere senkrecht zu den Seitenflächen 2, 3 erstreckt. Im Ausschnitt der Fig. 10 ist jedoch nur der Übergang der Kante 100 am Rand 11 einer Öffnung zu einer der Seitenflächen, hier als Seitenfläche 30 bezeichnet, zu sehen. Entsprechend dem Beispiel der Fig. 3 weist die Kante 10 neben den seitlich offenen Kanälen 41 auch ebene Kantenabschnitte 101 auf. Die Kante 10 wurde mithin durch Brechen an der durch die Kanäle 5 geschwächten Trennlinie erzeugt.

Der Abstand der Kanäle 41 ist in diesem Beispiel mit etwa 50 μm relativ groß. Der Abstand kann auch geringer gewählt werden, insbesondere im Falle, dass die Kanäle 41 ohne ebene Kantenabschnitte 101 direkt ineinander übergehen. Allgemein liegt der Abstand der Kanäle (auch als "Pitch" bezeichnet) vorzugsweise im Bereich von 3 bis 70 Mikrometern. Dieser Abstand wird dabei von Mitte zu Mitte der Kanäle gemessen. Die Querabmessung, beziehungsweise der Durchmesser der Kanäle 41 liegt vorzugsweise bei kleiner als 100 Mikrometern. Vorzugsweise liegt der Durchmesser in einem ähnlichen Bereich, wie der Abstand der Kanäle 5. Ohne Beschränkung auf die hier beschriebenen Beispiele wird ein Durchmesser bevorzugt, der im Bereich von 3 Mikrometern bis 50 Mikrometern liegt. Im Beispiel der Fig. 10 und Fig. 11 beträgt der Durchmesser etwa 30 Mikrometer.

Wie anhand der Fig. 10 und Fig. 11 ersichtlich ist, bilden sich durch das Ätzen insbesondere auch kalottenförmige Vertiefungen 37 aus.

Die Erfindung betrifft demgemäß allgemein, ohne Beschränkung auf die dargestellten Beispiele auch eine Mikrofluidikzelle 1 mit einem scheibenförmigen Glaselement 3 mit einer Dicke von höchstens 300 Mikrometern, welches zumindest eine langgestreckte Öffnung 10 aufweist, welche die beiden gegenüberliegenden parallelen Seitenflächen 30, 31 des Glaselements 3 verbindet, wobei jede der Seitenflächen 30, 31 des Glaselements 3 mit einem Glasteil 5, 7 verbunden ist, so dass die langgestreckte Öffnung 10 durch die beiden Glasteile 5, 7 verschlossen ist und einen zwischen den beiden Glasteilen 5, 7 eingeschlossenen, für die Führung von Flüssigkeiten geeigneten Hohlraum 9 bildet, wobei die Kante 100 der Öffnung 10, beziehungsweise dementsprechend der Teil der Wandung des Hohlraums, welcher durch die Kante 100 der Öffnung 10 gebildet wird, kalottenförmige Vertiefungen 37 aufweist.

Diese Struktur des Hohlraums 9 hat bei Mikrofluidikzellen den besonderen Vorteil, dass die kalottenförmigen Vertiefungen an den Seitenwandungen die Benetzbarkeit für Flüssigkeiten verbessern. Dies sorgt für eine verbesserte Befüllbarkeit der Zelle.

Diese Ausführungsform ist unabhängig von der Art und Weise, wie das Glaselement 3 mit den Glasteilen 5, 7 verbunden ist. Das oben beschriebene Verkleben wird bevorzugt, allerdings sind auch andere Verbindungsverfahren, wie etwa ein anodisches Bonden oder Direktbonden, sowie auch ein Verschweißen oder das Verlöten mit einem Glaslot möglich. Gemäß einer Weiterbildung der Erfindung ist das Glaselement 3 daher ohne Beschränkung auf spezielle Ausführungsbeispiele oder auf die Figuren mit zumindest einem der Glasteile 5, 7 durch eine Verklebung oder einen anodischen Bond oder einen Direktbond oder eine Verschweißung oder durch ein Glaslot verbunden. Bei der Verklebung wird das oben erläuterte strukturierte Beschichten mit einer Klebstoffschicht 15 bevorzugt.

Demgemäß ist in einer Weiterbildung der Erfindung vorgesehen, dass das Glaselement 3 mit zumindest einem der Glasteile 5, 7 durch eine Klebstoffschicht 15 verbunden ist, wobei die Klebstoffschicht 15 einen ausgesparten Bereich 13 um die zumindest eine Öffnung 10 aufweist, so dass der durch das Glasteil 5, 7 gebildete Teil 91 der Wandung des Hohlraums 9 von der Klebstoffschicht ausgespart ist. Insbesondere kann dabei also dieser Teil 91 der Wandung durch das Oberflächenmaterial des Glasteils 5, 7 gebildet werden. Die Bereiche 91 sind in Fig. 3 gekennzeichnet. Insbesondere ist in bevorzugter Ausgestaltung der Erfindung auch vorgesehen, dass die Kante 100 der Öffnung 10 im Glaselement klebstofffrei ist.

Die Tiefe der kalottenförmigen Vertiefungen 37 ist typischerweise, also im Mittel kleiner als 5 μm, bei Querabmessungen von im Mittel 5 - 20 μm. Gemäß einer Weiterbildung der Erfindung wird also das Ätzen so durchgeführt, dass zumindest eines der vorgenannten Merkmale der kalottenförmigen Vertiefungen gegeben ist.

Es ist ersichtlich, dass die Fläche der Kante 100 nicht nur durch die Vertiefungen 37, sondern besonders durch die Kanäle 41 größer ist, als die Fläche einer ebenen Kante. Auch diese Feinstruktur verbessert die Benetzbarkeit des Hohlraums 9.

Gemäß einem Aspekt der Erfindung ist daher eine Mikrofluidikzelle 1 mit einem Glaselement 3 mit zwei gegenüberliegenden Seitenflächen 30, 31 und einer durch eine Kante 100 begrenzten, langgestreckten Öffnung 10 vorgesehen, wobei an den Seitenflächen 30, 31 Glasteile 5, 7 befestigt sind, so dass die Öffnung 10 einen Hohlraum 9 zwischen den Glasteilen 5, 7 bildet, wobei die Kante 100 der Öffnung eine Vielzahl von parallel nebeneinander verlaufenden, seitlich offenen Kanälen 41 mit abgerundeter Wandung 54 und einer Querabmessung von kleiner als 200 μm aufweist, deren Längsrichtung 51 quer, vorzugsweise senkrecht zu den Seitenflächen 30, 31 des Glaselements 3 verläuft und die vorzugsweise auch an den Seitenflächen 30, 31, enden, beziehungsweise in diese münden. Auch diese Ausführungsform ist an sich unabhängig von der Art der Verbindung des Glaselements 3 mit den Glasteilen 5, 7, weiterhin auch unabhängig davon, ob sich durch das Ätzen kalottenförmige Vertiefungen ausbilden. Vorzugsweise sind aber sowohl die Vertiefungen 37 vorhanden, als auch eine Klebstoffschicht 15 zum Verbinden mit dem oder den Glasteilen 5, 7.

Würden die Kanäle 41 direkt aneinander angrenzen und genau halbkreisförmigen Querschnitt aufweisen, so wäre die Länge der Kantenlinie parallel zu den Seitenflächen 30, 31 um einen Faktor $\pi/2$ größer als die Kantenlinie einer glatten Kante. Die mit dem erfindungsgemäßen Verfahren erzielbaren Vergrößerungen der Fläche sind im Allgemeinen etwas kleiner und liegen typischerweise im Bereich von 10 bis 40 Prozent. Entsprechend ist in Weiterbildung der Erfindung vorgesehen, dass die Oberfläche der Kante 100 durch die Kanäle 41 gegenüber einer glatten Kantenfläche ohne Kanäle 41 um einen Faktor 1,1 bis 1,4 vergrößert ist.

Diese Vergrößerung der Oberfläche ergibt als weiteren Nebeneffekt eine gegenüber Biegebelastungen vergleichsweise bruchstabile Kante, was insofern überrascht, dass die Bruchwahrscheinlichkeit normalerweise mit der Fläche skaliert. Wahrscheinlich führen die gegenüber dem abgerundeten Kanal hervorstehenden Strukturen dazu, dass sich Defekte an diesen hervorstehenden Strukturen (Grate oder ebene Kantenabschnitte) nicht weit fortpflanzen können. Durch die Strukturierung der Kante 11 wird also die Rissfortpflanzung unterdrückt. Die Mikrofluidikzelle 1 ist also auch mechanisch stabiler.

Anhand der Fig. 10 und Fig. 11 ist die Feinstruktur der Kanäle 41 in Form von kalottenförmigen, beziehungsweise abgerundeten, kappenförmigen Vertiefungen 37 deutlich zu erkennen. Durch den bevorzugten langsamen Ätzprozess grenzen die kalottenförmigen Vertiefungen 37 aneinander an, wobei die aneinander stoßenden konkaven Rundungen der Vertiefungen 7 Grate 70 ausbilden.

Weiterhin ist zu erkennen, dass die Grate 70 in Aufsicht auf die Vertiefungen 37 gesehen polygonale Begrenzungslinien 71 der Vertiefungen 37 bilden. Dabei ist die mittlere Anzahl der Ecken 72 der Begrenzungslinien 71 der Vertiefungen 7 vorzugsweise auch kleiner als acht, vorzugsweise kleiner als sieben. Letzteres Merkmal ergibt sich dann, wenn die von den meisten kalottenförmigen Vertiefungen eingenommenen Gebiete im mathematischen Sinne konvex sind.

In einer Ausführungsform der Erfindung ist daher eine Mikrofluidikzelle 1 vorgesehen, bei welcher die kalottenförmigen Vertiefungen 37 in der Kante 100 der Öffnung 10 aneinander angrenzen und die aneinanderstossenden konkaven Rundungen der Vertiefungen 37 Grate 70 ausbilden. In Weiterbildung dieser Ausführungsform ist weiterhin vorgesehen, dass die Grate 70 in Aufsicht auf die Vertiefungen 37 gesehen polygonale Begrenzungslinien 71 der Vertiefungen 37 bilden.

Die Grate 70 des in Fig. 7 gezeigten Kanals 5 sind sehr schmal, es gibt keine erkennbaren Bereiche, in denen die konkaven Wölbungen der Vertiefungen 37 über einen konvex gewölbten Bereich am Grat 70 ineinander übergehen. Die Struktur der Kanäle 41 kann daher gemäß einer Weiterbildung der Erfindung auch so beschrieben werden, dass der Flächenanteil konvex geformter Bereiche in einem Kanal 41 kleiner als 5%, vorzugsweise kleiner als 2% ist.

Das Glaselement 3 des Beispiels der Fig. 10 und Fig. 11 ist ein silikatisches Glas mit niedrigem Alkaligehalt, im Speziellen ein Borosilikatglas mit einem Wärmeausdehnungskoeffizienten von $3,3*10^{-6}K^{-1}$. Als Borosilikatglas wird allgemein ein Glas mit folgender Zusammensetzung bevorzugt:

| Zusammensetzung | (Gew.-%) |
|---|---|
| $SiO_2$ | 63-83 |
| $Al_2O_3$ | 0-7 |
| $B_2O_3$ | 5-18 |
| $Li_2O + Na_2O + K_2O$ | 4-14 |
| $MgO + CaO + SrO + BaO + ZnO$ | 0-10 |
| $TiO_2 + ZrO_2$ | 0-3 |
| $P_2O_5$ | 0-2 |

Dieses Glas kann auch für die Glasteile 5, 7 verwendet werden.

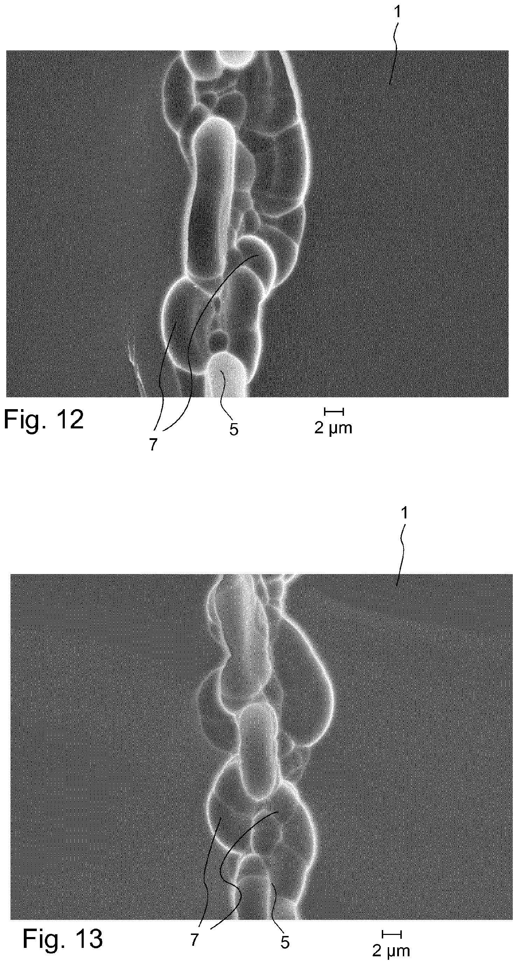

Die Fig. 12 und Fig. 13 zeigen elektronenmikroskopische Aufnahmen von Kanälen 41, die in ein Borosilikatglas, welches unter dem Markennamen D263 ® der Schott AG vertrieben wird, eingefügt wurden. Dabei wurden unterschiedliche Laserparameter verwendet. Bei dem Beispiel der Fig. 12 wurde ein Burst mit 8 Einzelpulsen eingesetzt, wobei die Repetitionsrate des Lasers 100 kHz betrug. Bei dem in Fig. 13 gezeigten Beispiel wurde eine höhere Repetitionsrate von 200 kHz eingesetzt, dafür aber ein Burst mit nur zwei Einzelpulsen. Für jeden Kanal 5 wurde jeweils aber nur ein einzelner Burst eingestrahlt. Die Kanäle 41 wurden dann in einer KOH-Lauge bei 80°C für eine Dauer von 8 Stunden geätzt. Die Struktur der Kanäle 41 ist ähnlich, wobei die kalottenförmigen Vertiefungen 34 aufgrund des im Vergleich zum Beispiel der Fig. 10 und Fig. 11 geringeren Durchmessers noch bauchiger erscheinen. Mit weiterem Aufätzen nähert sich die Struktur aber derjenigen der Fig. 10 und Fig. 11 an.

Noch ein weiteres Glas aus der Klasse alkaliarmer silikatischer Gläser, welches für die Herstellung einer Mikrofluidikzelle 1 gemäß der Erfindung gut geeignet ist, ist ein alkalifreies Alumosilikatglas. Bevorzugt wird dabei ein Glas mit folgender Zusammensetzung:

| Zusammensetzung | (Gew.-%) |
|---|---|
| $SiO_2$ | 50-75 |
| $Al_2O_3$ | 7-25 |
| $B_2O_3$ | 0-20 |
| $Li_2O + Na_2O + K_2O$ | 0-0,1 |
| $MgO + CaO + SrO + BaO + ZnO$ | 5-25 |
| $TiO_2 + ZrO_2$ | 0-10 |
| $P_2O_5$ | 0-5 |

Allgemein ist es günstig, ohne Beschränkung auf die oben genannten Zusammensetzungen Gläser mit Basizitäten im Bereich von 0,45 bis 0,55, bevorzugt im Bereich von 0,48 bis 0,54 zu verwenden. Dies macht die Gläser besonders geeignet für eine langsame, kontrollierte Ätzung mit basischen Ätzmedien, wobei aber auch eine Ätzung mit sauren Ätzmedien möglich bleibt. Es bietet sich an, diese Gläser dann jeweils nicht nur für das Glaselement 3, sondern auch für die Glasteile 5, 7 zu verwenden.

Gemäß noch einer Ausführungsform der Erfindung wird ein Glas mit einer sehr niedrigen Autofluoreszenz verwendet. Das Glas kann für das Glaselement 3 und/oder zumindest eines der Glasteile 5, 7, vorzugsweise für alle diese Bestandteile der Mikrofluidikzelle eingesetzt werden. Die Intensität der Autofluoreszenz wird durch die optische Basizität beeinflusst. Eine niedrige optische Basizität geht im Allgemeinen mit einer reduzierten Fluoreszenz einher, was für biotechnologische Anwendungen der Mikrofluidikzelle von Vorteil ist. So werden die Fluoreszenzmarker Cy3 und Cy5 oft für biotechnologische Anwendungen verwendet. Diese Marker fluoreszieren bei Wellenlängen von 570 nm und 670 nm, bei denen auch viele Gläser Autofluoreszenz zeigen. Die Autofluoreszenz verschlechtert das Signal-Rausch-Verhältnis in optischen Detektionsprozessen. Ein gemäß einer Ausführungsform der Erfindung für zumindest einen Bestandteil der Mikrofluidikzelle verwendetes Glas hat ein Verhältnis von Autofluorescence Emission zu Anregung von weniger als 1% bei 488 nm. Dazu hat das Glas eine optische Basizität $\Lambda$ von weniger als 0,6, vorzugsweise weniger als 0,55, besonders bevorzugt weniger als 0,53. Insbesondere werden optische Basizitäten von weniger als 0,52, vorzugsweise weniger als 0,51 für zumindest einen der Glas-Bestandteile, insbesondere sowohl für das Glaselement 3, als auch die beiden Glasteile 5, 7 verwendet. Nach einer Ausführungsform wird ein Glas mit niedriger optischer Basizität und niedriger Autofluoreszenz eingesetzt, welches folgende Glasbestandteile enthält:

| | |
|---|---|
| $SiO_2$ | >60 bis 90 mol% |
| $Al_2O_3$ | >0 bis 15 mol% |
| $B_2O_3$ | >4 bis 25 mol%, vorzugsweise >5 bis 25 mol%, |
| $R_2O$ | >0 bis <20 mol% |
| RO | 0 bis <20 mol% |

Dabei ist $R_2O$ die Summe der Gehalte der Alkalioxide $Li_2O$, $Na_2O$ und $K_2O$. RO ist die Summe der Gehalte von ZnO und der Erdalkalimetalloxide MgO, CaO, SrO, und BaO.

In einer spezielleren Ausführungsform enthält das Glas folgende Glasbestandteile:

| | |
|---|---|
| $SiO_2$ | >80 to <85 mol% |
| $Al_2O_3$ | >0.5 to <3 mol% |

(fortgesetzt)

| B$_2$O$_3$ | >8 to 15 mol% |
|---|---|
| R$_2$O | >0 to <5 mol% |
| RO | 0 to <5 mol% |

Gemäß noch einer Weiterbildung der Ausführungsform mit einem Glas mit niedriger Autofluoreszenz und niedriger optischer Basizität gilt für das Mengenverhältnis $x_{B3+}/x_{Al3+}$ der molaren Gehalte von Bor zu Aluminium

$$\frac{x_{B3+}}{x_{Al3+}} \geq 7.5, \qquad \text{vorzugsweise } \frac{x_{B3+}}{x_{Al3+}} \geq 10.$$

Das Verhältnis ist andererseits vorzugsweise $\frac{x_{B3+}}{x_{Al3+}} \leq 25$, insbesondere $\frac{x_{B3+}}{x_{Al3+}} \leq 20$, oder $\frac{x_{B3+}}{x_{Al3+}} \leq 15$.

Einige Komponenten von Gläsern haben auch einen negativen Einfluss auf die UV-Transmission. Bei besonders geeigneten Gläsern sind die Gehalte dieser Komponenten begrenzt. So sind gemäß noch einer alternativen oder zusätzlichen Ausgestaltung der Erfindung die Gehalte von SnO$_2$, Sb$_2$O$_3$, CeO$_2$, TiO$_2$ und/oder Fe$_2$O$_3$ jeweils im Bereich von 0 bis 0,5 mol%, vorzugsweise weniger als 0,01 mol%.

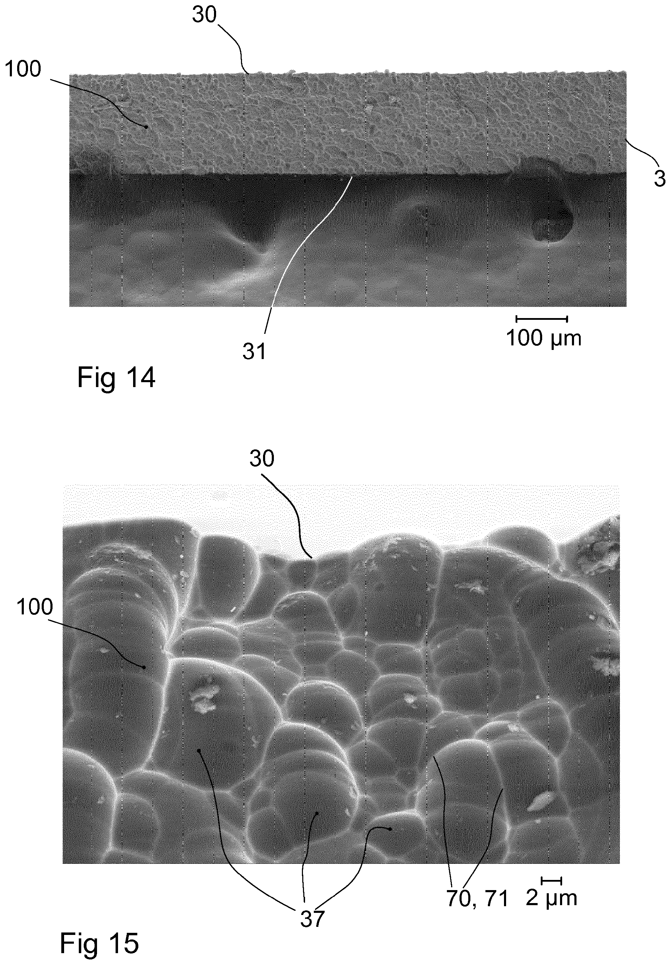

Fig. 14 und Fig. 15 zeigen zwei weitere elektronenmikroskopische Aufnahmen der Kante 100 eines Glaselements 3. Dabei zeigt Fig. 14 die Kante 100 in voller Breite des Glaselements 3. Fig. 15 zeigt die Kante 100 in hoher Vergrößerung am Übergang zu einer der Seitenflächen 30. Die Kante 100 wurde wie oben beschrieben hergestellt, indem die Kanäle 37 beim Ätzen so weit aufgeweitet werden, dass sich diese vereinigen und eine durchgehende Kante bilden, so dass ein Teil vom Glaselement 3 abgelöst werden kann. Die Kanäle 37 sind im Verlauf des Ätzens verflacht, so dass eine im Wesentlichen ebene Kante 100 erhalten wird, die eine Vielzahl von aneinander angrenzenden, abgerundeten, kalottenförmigen Vertiefungen 37 aufweist. Dieses Beispiel zeigt, dass das Merkmal der kalottenförmigen Vertiefungen unabhängig vom Merkmal von quer zur Kante verlaufenden Kanälen 41 ist und auch eine Ausführungsform ohne solche Kanäle 41 realisierbar ist.

Fig. 15 zeigt, dass die Vertiefungen 37 auch hier durch Grate 70 getrennt, die in etwa polygonale Begrenzungslinien 71 bilden. Was insbesondere bei der Aufnahme der Fig. 14 auffällt, ist, dass die Kante 100 in Richtung senkrecht zu den Seitenflächen 30, 31 geradlinig und auch im Wesentlichen senkrecht zu den Seitenflächen verläuft. Ebenso ist auch der Übergang von der Kante 100 zu den Seitenflächen 30, 31, praktisch nicht verrrundet. Die Form dieser Kante 100, wie sie insbesondere auch für die Stege 19 zwischen Öffnungen 10 geeignet ist, kann mit den oben genannten Eigenschaften wie folgt charakterisiert werden: Die Neigung, beziehungsweise der Winkel der Kantenfläche 100 zur angrenzenden Seitenfläche 30, 31 beträgt mindestens 85° in der an die Seitenfläche angrenzenden Hälfte der Kantenfläche. Damit verläuft die Kantenfläche 10 im Wesentlichen rechtwinklig zu den Seitenflächen 30, 31, mit einer Abweichung von maximal 5 ° vom rechten Winkel.

Wie am Beispiel der Fig. 15 weiterhin zu erkennen ist, ist der Übergangsbereich, in dem die Neigung der Kante 100 in die angrenzende Seitenfläche 30 übergeht, schmal und von der Größenordnung der Ausdehnung der kalottenförmigen Vertiefungen 37. Gemäß einer Weiterbildung ist daher vorgesehen, dass der mittlere Kantenradius am Übergang von der Seitenfläche 30, 31 in die im Wesentlichen senkrecht zur Seitenfläche 30, 31 ausgerichtete Kante 100 maximal 10 Mikrometer beträgt.

Durch die hohe Stabilität und Festigkeit der erfindungsgemäß hergestellten Kanten einer Öffnung 10 im Glaselement 3 ist die Erfindung besonders für komplexe und fragile Strukturen, welche mit anderen Verfahren nicht herstellbar sind, geeignet. Dazu zählen auch nicht symmetrische Ausschnitte mit dünnen und/oder langen Stegen. Es wurde jedoch auch festgestellt, dass die Stabilität des Glaselements 3 massiv von der Geometrie abhängig ist. Genauer wurde festgestellt, dass es günstig ist, bei einer Struktur, die durch einen oder mehrere Stege in Öffnungen im Glaselement gehalten wird, eine bestimmte geometrische Vorgabe einzuhalten. Mit dieser Vorgabe wird eine hinreichende Stabilität und Handhabbarkeit gewährleistet. Im Speziellen ist dazu ein Glaselement 3 vorgesehen, welches zumindest zwei Öffnungen 10 aufweist, derart, dass zwischen den Öffnungen 10 eine Struktur mit mindestens einem Steg 19 gebildet wird. Dabei kann der Struktur ein Parameter G zugeordnet werden, welcher durch die Beziehung

$$G = \frac{l_1^2}{l_2 \cdot b \cdot \sqrt[3]{h} \cdot N}$$

gegeben ist. Erfindungsgemäße Glaselemente 3 in Mikrofluidikzellen lassen sich dabei mit guter mechanischer Stabilität noch realisieren, wenn der Parameter G mindestens 10 mm$^{-1/3}$, vorzugsweise mindestens 50 mm$^{-1/3}$, besonders bevorzugt mindestens 100 mm$^{-1/3}$ beträgt. Umgekehrt ist es ausreichend, wenn der Parameter höchstens 400 mm$^{-1/3}$, bevorzugt höchstens 300 mm$^{-1/3}$, besonders bevorzugt höchstens und 200 mm$^{-1/3}$ beträgt.

Die Variable h in der obigen Beziehung bezeichnet die Dicke des Glaselements 3, also eine Dicke von höchstens 300 Mikrometern.

Fig. 16 zeigt zur Verdeutlichung der Parameter der Beziehung ein Glaselement 3 mit einer einfachen Struktur, die in diesem Fall nur einen Steg 19 umfasst, welcher zwischen zwei Öffnungen 10 verläuft.

In der obigen Beziehung bezeichnet $l_1$ die längste Kantenlänge zwischen zwei benachbarten entlang der Kante der Struktur liegenden Kontaktpunkten oder Kontaktgebieten 44 eines oder zweier verschiedener Stege 19 mit dem Glaselement 3. Dieses Maß bezeichnet also die Bogenlänge der längsten Kante zwischen zwei benachbarten Kontaktgebieten 44. Die Kanten 46, 47 des Stegs 19 können, wie auch das Beispiel der Fig. 16 zeigt, je nach Formgebung unterschiedliche Längen aufweisen. Bei dem gezeigten Beispiel weist die Kante 46 eine größere Länge auf, als die Kante 47. Der Parameter $l_1$ ist hier also die Bogenlänge dieser Kante 46. Die Kontaktgebiete 44 sind die Übergangsbereiche des Glases, an denen der Steg 19 in das die Öffnungen 10 umgebende Glas, beziehungsweise in die Basis 43, übergeht. Dabei ist ein Kontaktgebiet 44 definiert als kreisförmiger Bereich mit einem Durchmesser von 1mm, der so am Steg 19 positioniert ist, dass dessen Rand beide Kanten des Stegs 19, also auch die Ränder beider Öffnungen 10 berührt. Zur Berechnung des Parameters G kann dabei die Position des gedachten Kontaktgebiets 44 bestimmt werden, indem das kreisförmige Gebiet von der Basis 43 in Richtung auf den Steg 19 verschoben wird. Die Position ist erreicht, wenn das Gebiet gerade noch vollständig auf das Glas passt und dessen Rand die Ränder der Öffnungen 10 berührt. Demzufolge gilt diese Beziehung und die erfindungsgemäße Geometrie für Stege mit einer minimalen Stegbreite von kleiner als 1 mm.

Die Länge $l_2$ bezeichnet den kürzesten geradlinigen Abstand zweier Kontaktbereiche 44 an den Enden des Stegs 19. Für beide Längen l1 und l2 ist die Entfernung von Rand zu Rand der kreisförmigen Kontaktbereiche 44 maßgeblich. Bei mehr als zwei Kontaktgebieten 44 müssen die Pfade der Längen $l_1$ und $l_2$ nicht notwendig zwischen denselben Kontaktgebieten 44 verlaufen. Der in Fig. 16 eingezeichnete Doppelpfeil zur Bezeichnung der Länge l2 endet dementsprechend auch an den Rändern der Kontaktbereiche 44.

Der Parameter b schließlich bezeichnet den geringsten Abstand der Öffnungen 10 zueinander entlang des Stegs 19, beziehungsweise mit anderen Worten die minimale Stegbreite.

Eine derartige Geometrie, wie sie vorstehend beschrieben wurde, ist hinsichtlich der Festigkeit und Handhabbarkeit besonders vorteilhaft in Verbindung mit der erfindungsgemäßen Ausbildung der Kante, also mit kalottenförmigen Vertiefungen. Allerdings kann eine derartige Geometrie auch mit andersartig ausgebildeten Kanten eingesetzt werden.

Bei dem dargestellten Beispiel ist nur ein einzelner Steg 19 vorhanden. Es sind aber auch eine Vielzahl Strukturen möglich, die von mehr als einem Steg getragen werden können. Wichtig dabei ist, dass bei mehreren Stegen die Pfade $l_1$ und $l_2$ zwischen unterschiedlichen Kontaktgebieten 44 verlaufen können. Zur Bewertung der Stabilität eines Designs setzt G die längste mögliche Strecke zwischen zwei Kontaktgebieten $l_1$ also in Beziehung zur kürzest möglichen Verbindung $l_2$ zweier Kontaktpunkte. Dies können wie gesagt auch unterschiedliche Kontaktgebiete sein. Für die Anzahl N der Kontaktbereiche 44 gilt grundsätzlich N≥2.

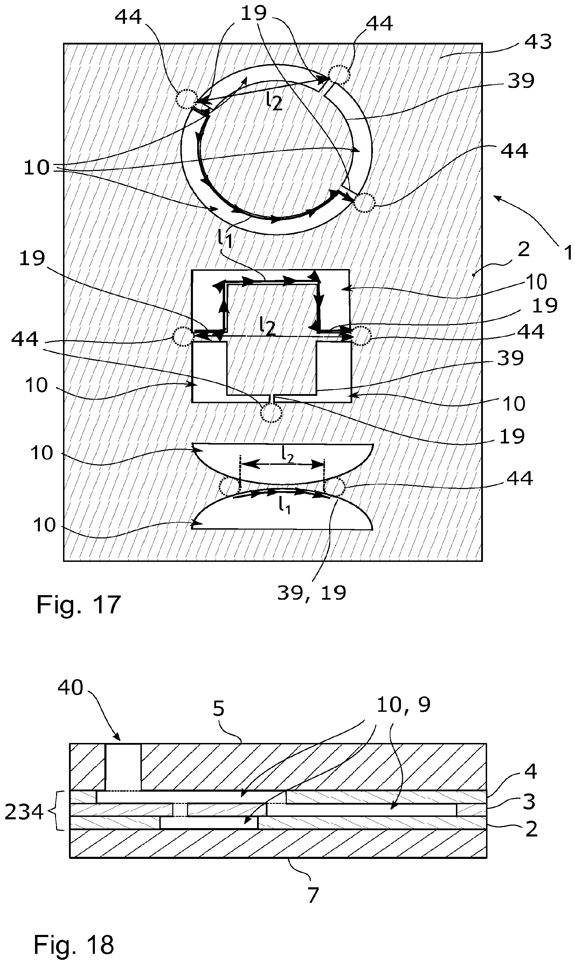

Fig. 17 zeigt zur weiteren Verdeutlichung ein Glaselement 3 mit drei verschiedenen Strukturen 39, die aus Glasabschnitten zwischen mehreren Öffnungen 10 gebildet werden. Die obere Struktur 39 ist kreisförmig und an drei Stegen 19 gehaltert. Die Struktur 39 in der Mitte des Glaselements 3 ist ebenfalls an drei Stegen 19 gehaltert, hat aber eine rechteckige Form. Die unterste Struktur 39 besteht ähnlich wie das Beispiel der Fig. 16 lediglich aus einem einzelnen Steg 19. Dieser verjüngt sich aber zur Mitte hin. Dabei verjüngt sich die Stegbreite von einer Breite von deutlich mehr als 1 mm zu einer Stegbreite kleiner als 1 mm in der Mitte hin. Dementsprechend liegen auch die Kontaktgebiete 44 zur Berechnung des Parameters G auf dem Steg 19, nämlich so, dass deren Rand die Kanten des Stegs 19 an der Stelle berühren, an welcher der Abstand der Kanten 1 mm unterschreitet.

Anhand der beiden oberen Strukturen 39 ist ersichtlich, dass der Abstand $l_2$ und die Bogenlänge $l_1$ zwischen den Kontaktgebieten 44 an unterschiedlichen Stegen berechnet werden kann. Für den Parameter G ist die längste Kantenlänge $l_1$ zwischen zwei entlang der Kante der Struktur benachbart liegenden Kontaktpunkten 44 maßgeblich. Diese ist für beide Strukturen 39 jeweils eingezeichnet. Insbesondere ergibt sich im Beispiel der obersten, kreisförmigen Struktur 39 ein kürzester Abstand $l_2$ zwischen zwei Kontaktgebieten 44 und eine längste Kantenlänge $l_1$ zwischen zwei anderen, benachbarten Kontaktgebieten 44.

Demgemäß ist in einer Ausführungsform der Erfindung, auch unabhängig von der Morphologie der Kanten, eine Mikrofluidikzelle 1 mit einem plattenförmigen Glaselement 3 mit einer Dicke von höchstens 700 Mikrometern, vorzugsweise höchstens 300 Mikrometern und zwei gegenüberliegenden Seitenflächen 30, 31 vorgesehen, wobei im Glaselement 3 mindestens zwei Öffnungen 10 eingefügt sind, derart, dass der Bereich des Glaselements 3 zwischen den Öffnungen eine Struktur 39 mit mindestens einem Steg 19 bildet, dessen minimale Breite kleiner als 1 mm beträgt, wobei für die Struktur ein Parameter G definiert ist, der gegeben ist durch die oben angegebene Beziehung, wobei der Parameter G einen Wert von mindestens 10 mm$^{-1/3}$ und von höchstens 400 mm$^{-1/3}$ aufweist, wobei $l_1$ die längste Kantenlänge zwischen zwei entlang der Kante einer der Öffnungen 13 benachbarten Kontaktgebieten 44 und $l_2$ die Länge der kürzest möglichen geradlinigen Verbindung zwischen zwei Kontaktgebieten 44 ist, und wobei ein Kontaktgebiet 44 eines Stegs 19 jeweils als kreisförmiger Bereich des Glaselements 3 mit einem Durchmesser von 1 mm definiert ist, welches so am Steg 19 angeordnet ist, dass deren Rand die Ränder beider Öffnungen 10, deren Zwischenbereich den Steg 19 bildet, an jeweils mindestens einem Punkt berührt, und wobei b die minimale Stegbreite, h die Dicke des Glaselements 1 und N die Anzahl der Kontaktgebiete 44 bezeichnen. Für diese Ausführungsform sind Stege mit einer minimalen Breite von nicht weniger als 300 $\mu$m bevorzugt.

Bei den oben beschriebenen Ausführungsbeispielen der Erfindung umfasst die Mikrofluidikzelle eine Sandwichstruktur mit drei Ebenen, nämlich den Glasteilen 5, 7 und dem zwischenliegenden Glaselement 3. Die Begriffe "Glaselement" einerseits und "Glasteil" anderseits sind im Sinne der Beschreibung lediglich zur einfacheren Unterscheidung der verschiedenen Lagen der Sandwichstruktur gewählt. Nun kann eines der Glasteile, beispielsweise das Glasteil 5 seinerseits wieder als Glaselement 3 mit mindestens einer Öffnung 10 ausgeführt sein, welche durch ein weiteres Glasteil unter Bildung eines Hohlraums verschlossen wird, wobei auch das weitere Glasteil wiederum ein mit einer Öffnung strukturiertes Glaselement 3 sein kann, etc. Bezeichnet man wie in der obigen Beschreibung die äußeren Glaselemente als Glasteile 5, 7 wird eine Mikrofluidikzelle 1 mit einer Mehrlagenstruktur erhalten. Eine solche Mikrofluidikzelle 1 zeigt das Beispiel der Fig. 18. Die Mikrofluidikzelle 1 umfasst hier drei Glaselemente 2, 3, 4 mit Öffnungen 10, die durch die anderen Elemente verschlossen sind und Hohlräume 9 bilden. Die Glaselemente 2, 3, 4 bilden einen Stapel 234. Zwei Glasteile 5, 7 bilden Boden und Deckel der Mikrofluidikzelle 1. Wie im Beispiel der Fig. 1 bis Fig. 3 ist in einem Glasteil 5 eine Einfüllöffnung 40 vorgesehen. Vorzugsweise sind alle Teile, also die Glaselemente 2, 3, 4 und die abschließenden Glasteile 5, 7 miteinander verklebt, wobei die jeweiligen Klebstoffschichten erfindungsgemäß Aussparungen um die Öffnungen 10 aufweisen. Wie dargestellt ist es sinnvoll, wenn die Hohlräume in den einzelnen Glaselementen 2, 3, 4 miteinander kommunizieren. Gemäß einer Ausführungsform bildet zumindest ein Teil der Hohlräume eine mehrlagige Anordnung kommunizierender Kanäle. Im einfachsten Fall werden die Verbindungen zwischen den Hohlräumen 9 allgemein, ohne Beschränkung auf das spezielle Beispiel geschaffen, geschaffen, indem die Öffnungen 10 verschiedener Glaselemente 2, 3, 4 überlappen.

Gemäß einer Ausführungsform der Erfindung ist also eine Mikrofluidik-Zelle 1 vorgesehen, welche einen Stapel 234 mit mindestens zwei miteinander verbundenen scheibenförmigen Glaselementen 2, 3, 4 aufweist, sowie zwei Glasteile 5, 7, welche mit dem Stapel 234 verbunden sind und zwischen denen der Stapel 234 angeordnet ist, wobei die Glaselemente 2, 3, 4 jeweils mindestens eine vorzugsweise langgestreckte Öffnung 10 aufweisen, welche durch die Verbindung mit angrenzenden Glaselementen 2, 3 ,4 oder Glasteilen 5, 7 verschlossen ist und dadurch einen Hohlraum 9 bildet, der für die Führung von Flüssigkeiten geeignet ist. Vorzugsweise kommunizieren wie gesagt die Hohlräume 9 in den verschiedenen Glaselementen miteinander. Weiterhin erfolgt die Verbindung von Glaselementen 2, 3, 4 und Glasteilen 5, 7 wie dargelegt durch Klebstoffschichten 15, welche die Öffnungen 10 aussparen. Weiterhin ist bevorzugt, dass die Öffnungen 10 mit dem hier erläuterten Verfahren durch Einfügen filamentförmiger Schädigungen und Aufätzen zu Kanälen 41 erzeugt werden, so dass die Kanten 100 der Öffnungen kalottenförmige Vertiefungen aufweisen.

Bei den bisher vorgestellten Ausführungsformen der Erfindung sind die Strukturierungen von Glaselementen 2, 3, 4 und Glasteilen 5, 7 in Form von Öffnungen ausgeführt, welche durch das jeweilige Glaselement, beziehungsweise Glasteil hindurchgehen. Es ist mit dem oben beschriebenen lasergestützten Ätzverfahren aber auch möglich, einseitig offene Vertiefungen oder Ausnehmungen zu erzeugen. Solche Strukturen können in vorteilhafter Weise mit Öffnungen 10 oder 40 kombiniert werden, um fluidführende Anordnungen in der Mikrofluidikzelle 1 zu erzeugen. Allgemein, ohne Beschränkung auf spezielle hier beschriebene Beispiele ist daher in einer Ausführungsform der Erfindung vorgesehen, dass ein Glaselement 2, 3, 4 und/oder Glasteil eine einseitig offene Ausnehmung oder Vertiefung aufweist, welche Bestandteil einer für die Führung von Flüssigkeiten geeigneten Struktur ist, insbesondere, welche Bestandteil eines mit einer Öffnung 10 im Glaselement 3 gebildeten Hohlraumes 9 ist oder mit dem Hohlraum 9 kommuniziert.

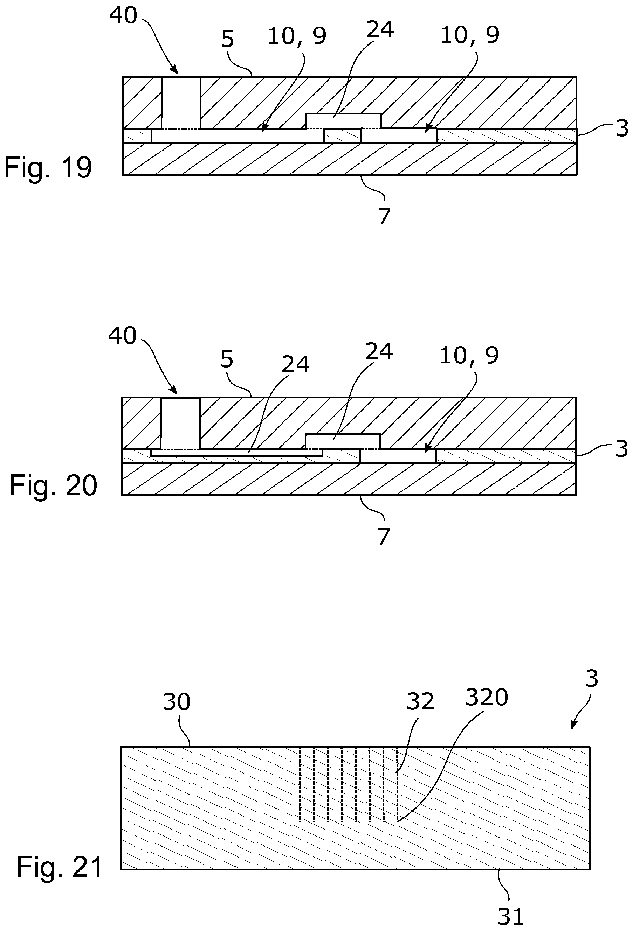

Fig. 19 zeigt ein Beispiel einer solchen Mikrofluidikzelle 1. Bei diesem Beispiel weist das Glaselement 3 zwei nebeneinander liegende Öffnungen 10 auf, die durch das Glasteil 5 verschlossen werden, so dass Hohlräume 9 entstehen. Das Glasteil 5 weist eine Ausnehmung 24 auf, die so angeordnet ist, dass sie die beiden Hohlräume 9 verbindet, so dass die beiden Hohlräume 9 über die Ausnehmung 24 kommunizieren.

Fig. 20 ist eine Variante, bei welcher eine Ausnehmung 24 im zwischen den Glasteilen 5, 7 angeordneten Glaselement 3 eingefügt ist. Die Ausnehmung 24 bildet beispielsweise einen Kanal zur Verbindung eines Hohlraums 9 mit der Einfüllöffnung 40.

Das Verfahren zur Herstellung einer solchen Vertiefung oder Ausnehmung 24 basiert vorzugsweise auf einer Variante des oben erläuterten laserbasierten Verfahrens, bei welchem mit einem Ultrakurzpuls-Laser eingefügte filamentförmige Schädigungen durch Ätzen aufgeweitet werden. Das Verfahren basiert allgemein, ohne Beschränkung auf die dargestellten Beispiele darauf, dass

-  der Laserstrahl 27 eines Ultrakurzpulslasers 29 auf eine der Seitenflächen 30, 31 des Glaselements 3 oder Glasteils

5, 7 gerichtet und mit einer Fokussierungsoptik 23 zu einem langgezogenen Fokus im Glas konzentriert wird, wobei durch die eingestrahlte Energie des Laserstrahls 27 filamentförmige Schädigungen 32 im Volumen des Glases erzeugt werden, deren Längsrichtung quer zur Seitenfläche 30, 31, insbesondere senkrecht zur Seitenfläche 30, 31 des Glaselements 3 oder Glasteils 5, 7 verläuft und zur Erzeugung einer filamentförmigen Schädigung der Ultrakurzpulslaser 29 einen Puls oder ein Pulspaket mit mindestens zwei aufeinander folgenden Laserpulsen einstrahlt, wobei der Laserstrahl 27 so eingestrahlt wird, dass ein Ende des langgezogenen Fokus innerhalb des Glases liegt, so dass auch die filamentförmige Schädigung 32 im Glas endet, sich aber bis zu einer Seitenfläche 31, 32 erstreckt,

und wobei nach dem Einfügen der filamentförmigen Schädigungen 32

- das Glas einem Ätzmedium ausgesetzt wird, welches das Glas des Glaselements 3 mit einer Abtragsrate vorzugsweise kleiner als 8 $\mu$m pro Stunde abträgt und
- die filamentförmigen Schädigungen 32 zu einem Kanal 41 aufweitet, so dass aufgrund der im Glas endenden filamentförmigen Schädigungen 32 die Kanäle 41 ebenfalls im Glas enden und einseitig geschlossen sind, wobei sich die Kanäle 41 beim Ätzen seitlich vereinigen, so dass eine Ausnehmung 24 im Glas erzeugt wird. Die seitliche Begrenzung der Ausnehmung wird demnach wie bei der Ausführungsform mit der Erzeugung einer Öffnung 10 durch den Pfad der nebeneinander liegenden Auftreffpunkte des Laserstrahls bestimmt. Das Verfahren eignet sich besonders für Ausnehmungen mit einer Tiefe bis 5 mm. Die Tiefe kann mindestens 50 $\mu$m, bevorzugt mindestens 100 $\mu$m, besonders bevozugt mindestens 200 $\mu$m betragen.

Fig. 21 zeigt ein Glaselement 3 mit darin eingefügten filamentförmigen Schädigungen 32 gemäß der vorstehend erläuterten Ausführungsform der Erfindung. Die filamentförmigen Schädigungen 32 weisen eine Länge auf, die kleiner ist, als die Dicke des Glaselements 3. Folglich liegt ein Ende 320 der filamentförmigen Schädigungen 32 im Inneren des Glaselements 3. Die filamentförmigen Schädigungen 32 werden dann mit dem Ätzmedium beaufschlagt, was insofern ungewöhnlich ist, als dass die Ätzlösung in die nur einseitig an der Oberlfläche endenden filamentförmigen Schädigungen 32 eindringen und die homogene, d.h. isotrope Aufweitung bewirken kann.

Zum Erzeugen von Ausnehmungen oder Vertiefungen 24, die nur eine Öffnung zu einer der Seitenflächen 30, 31 des Glaselements 3 oder Glasteils 5, 7 aufweisen, werden die filamentförmigen Schädigungen 32 gemäß einer Ausführungsform der Erfindung in einem zweidimensionalen Raster eingefügt.

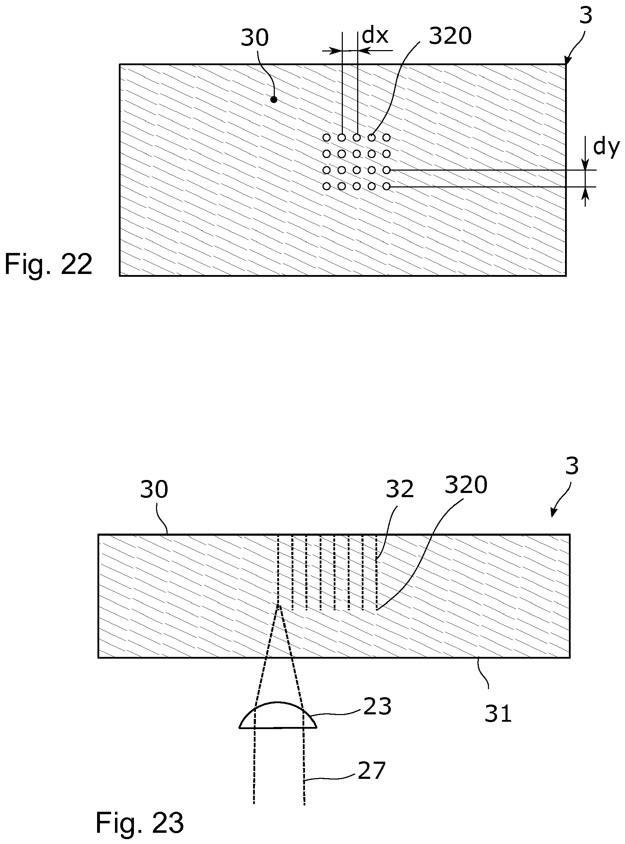

Fig. 22 zeigt schematisch eine Aufsicht auf eine Seitenfläche 30 eines Glaselements 3 oder Glasteils 5, 7 mit einer matrixförmigen, beziehungsweise rasterförmigen Anordnung von filamentförmigen Schädigungen 32, im Beispiel in einer 4x5 Anordnung. Die mit dieser rasterförmigen Anordnung der filamentförmigen Schädigungen 32 nach dem Ätzprozess erzeugbare Innenkontur ist dementsprechend von rechteckiger Form. Es ist dem Fachmann ersichtlich, dass sich je nach Anordnung der filamentförmigen Schädigungen 32 auf der Seitenfläche des Substrates verschiedene geometrische Figuren erzeugen lassen, beispielsweise auch Ausnehmungen 24 mit allgemeim polygonaler, beispielsweise dreieckiger Form oder kreisförmiger Grundform, sowie auch Freiformflächen. In Fig. 22 ist der Abstand zweier benachbarter filamentförmigen Schädigungen 32 in den zwei Dimensionen mit dx und senkrecht dazu mit dy angegeben. Bei einer matrixförmigen Anordnung der filamentförmigen Schädigungen 32 können die Abstände in diesen beiden Richtungen gleich sein, müssen es aber nicht, so dass auch die Bedingung dx ≠ dy möglich ist. Das Raster muss auch nicht rechteckförmig oder matrixförmig sein. Die Orte der filamentförmigen Schädigungen können auch beispielsweise reihenweise versetzt sein, so dass ein Raster mit hexagonaler oder dreieckförmiger Elementarzelle entsteht. Gemäß einer Ausführungsform der Erfindung beträgt einer der Abstände dx oder dy wenigstens 10 $\mu$m, bevorzugt wenigstens 20 $\mu$m und der andere Abstand wenigstens 4 $\mu$m, bevorzugt wenigstens 5 $\mu$m, besonders bevorzugt wenigstens 10 $\mu$m, ganz besonders bevorzugt 20 $\mu$m, wobei beide Abstände dx, dy natürlich auch gleich sein können. Besonders bei der Herstellung einseitig offener Ausnehmungen sind an sich kleine Abstände der filamentförmigen Schädigungen wünschenswert. Allerdings können sich die Schädigungen gegenseitig beeinflussen, da eine zuvor eingebrachte Schädigung die Lichtausbreitung beim Einbringen einer benachbarten Schädigung stören kann. Generell ist dazu in einer Ausführungsform der Erfindung vorgesehen, dass der Abstand benachbarter Filamente mindestens 50·R, bevorzugt mindestens 100·R beträgt, wobei R der Radius einer filamentförmigen Schädigung ist. Allgemein, ohne Beschränkung auf dargestellte Beispiele kann es weiterhin zur Verringerung der gegenseitigen Beeinflussung der Schädigungen günstig sein, wenn benachbarte Schädigungen nicht direkt nacheinander eingefügt werden. Vielmehr kann ein intermittierender Modus verwendet werden, bei welchem zunächst filamentförmige Schädigungen in einem ersten, größeren Abstand und in einem weiteren Schritt dann zusätzliche filamentförmige Schädigungen zwischen den bereits vorhandenen Schädigungen 32 eingefügt werden. Bei den später in die Zwischenräume eingefügten Schädigungen kann es dann durch Beeinflussung des Lichtstrahls durch die schon vorhandenen Schädigungen zu einer reduzierten Länge der Schädigung kommen. Dennoch ermöglicht die so erzielte dichte Anordnung von filamentförmigen Schädigungen dann ein schnelles Freilegen der Ausnehmung. Gegebenenfalls kann die Abfolge der filamentförmigen Schädigungen unterschiedlicher Länge dabei als charakteristisches Muster am Boden der herausgeätzten Ausnehmung zu erkennen sein. Generell kann eine Einfügung von filamentförmigen Schädigungen 32 in einem zweiten Schritt zwischen bereits vorhandenen filamentförmigen Schädigungen 32 vorteilhaft auch bei der Ausführungsform eingesetzt werden, bei welcher eine Öffnung 10 in das Glaselement 3 eingefügt wird.

Fig. 23 zeigt eine Anordnung zum Einfügen der im Glas endenden filamentförmigen Schädigungen. Prinzipiell kann eine Vorrichtung verwendet werden, wie sie auch in Fig. 5 dargestellt ist. Die Fokussierungsoptik 23 kann nun so angepasst werden, dass ein Ende des langgestreckten Fokus im Glas liegt. Günstig ist es, wenn das im Glas liegende Ende des Fokus wie dargestellt zur derjenigen Seitenfläche 30 weist, auf welche der Laserstrahl 27 auftrifft. Mit anderen Worten wird die filamentförmige Schädigung 32 also so eingefügt, dass deren im Glas liegendes Ende zum einfallenden Laserstrahl 27, beziehungsweise auf die Fokussierungsoptik 23 weist. Diese Konfiguration ist günstig, da hier kleine Filamentabstände gewählt werden können, da es auf der Einstrahlseite zu weniger Verschmutzungen durch den Laserprozess kommt.

Bezugszeichenliste

| 1 | Mikrofluidikzelle |
|---|---|
| 2, 3, 4 | scheibenförmiges Glaselement |
| 5, 7 | Glasteil |
| 9 | Hohlraum |
| 10 | Öffnung in 3 |
| 11 | Rand von 10 |
| 12 | Klebstoff |
| 13 | ausgesparter Bereich |
| 15 | Klebstoffschicht |
| 16 | Rand von 15 |
| 17 | Druckvorrichtung |
| 18 | Druckkopf |
| 19 | Steg |
| 20 | Rechner |
| 21 | Laserbearbeitungsvorrichtung |
| 23 | Fokussierungsoptik |
| 24 | Ausnehmung |
| 27 | Laserstrahl |
| 29 | Ultrakurzpulslaser |
| 30, 31 | Seitenflächen von 3 |
| 32 | filamentförmige Schädigung |
| 35 | Kanal |
| 37 | kalottenförmige Vertiefung |
| 39 | Struktur mit mehreren Öffnungen 10 |
| 40 | Öffnung in 5, 7 |
| 43 | Basis |
| 41 | Kanal |
| 44 | Kontaktgebiet |
| 47 | Positioniereinrichtung |
| 48 | Positionierungsmarker |
| 45 | Recheneinrichtung |

(fortgesetzt)

| 51 | Längsrichtung von 41 |
|---|---|
| 52 | Grat |
| 54 | Wandung von 41 |
| 70 | Grat |
| 71 | polygonale Begrenzungslinie |
| 72 | Ecke von 71 |
| 73 | Auftreffpunkt des Laserstrahls 27 |
| 90 | Innenteil |
| 91 | Von 5, 7 gebildeter Teil der Wandung von 9 |
| 100 | Kante von 10 |
| 101 | ebener Kantenabschnitt |
| 234 | Stapel von Glaselementen 2, 3, 4 |
| 320 | Ende von 32 |

## Patentansprüche

1. Verfahren zur Herstellung von Mikrofluidik-Zellen (1), bei welchem ein scheibenförmiges Glaselement (3) mit einer Dicke von höchstens 700 Mikrometern so strukturiert wird, dass dieses zumindest eine Öffnung (10) aufweist, welche die beiden gegenüberliegenden parallelen Seitenflächen (30, 31) des Glaselements verbindet, und wobei jede der Seitenflächen (30, 31) des Glaselements (3) mit einem Glasteil (5, 7) verbunden wird, so dass die Öffnung (10) durch die beiden Glasteile (5, 7) verschlossen und eine Mikrofluidik-Zelle (1) mit einem zwischen den beiden Glasteilen (5, 7) eingeschlossenen, für die Führung von Flüssigkeiten geeigneten Hohlraum (9) gebildet wird, wobei das Verbinden des Glaselements (3) mit zumindest einem der beiden Glasteile (5, 7) durch einen vorzugsweise auf die Seitenfläche (30, 31) des Glaselements (3) aufgetragenen Klebstoff (12) erfolgt, wobei beim Auftrag des Klebstoffs (12) die zumindest eine Öffnung (10) im Glaselement (3) ausgespart wird.

2. Verfahren gemäß dem vorstehenden Anspruch, **dadurch gekennzeichnet, dass** das Glaselement (3) mit einer Öffnung (10) mit einer langgestreckten Form strukturiert wird, so dass mit dem Verschließen der Öffnung (10) durch die Glasteile (5, 7) ein Hohlraum (9) in Form eines fluidleitenden Kanals geschaffen wird.

3. Verfahren gemäß dem vorstehenden Anspruch, **dadurch gekennzeichnet, dass** der Auftrag des Klebstoffs (12) mittels eines strukturierten Auftragsverfahrens, insbesondere eines Druckverfahrens erfolgt, bei welchem der Klebstoff selektiv unter Aussparung eines sich über die Öffnung (10) im Glaselement (3) erstreckenden Bereichs (13) auf die Seitenfläche (30, 31) aufgetragen wird.

4. Verfahren gemäß dem vorstehenden Anspruch, **dadurch gekennzeichnet, dass** der Aufdruck des Klebstoffs (12) so erfolgt, dass der ausgesparte Bereich (13) größer als die Öffnung ist, so dass der Rand (16) der aufgetragenen Klebstoffschicht (15) vom Rand (11) der Öffnung (10) beabstandet, insbesondere zurückgesetzt ist.

5. Verfahren gemäß einem der vorstehenden Ansprüche, **dadurch gekennzeichnet, dass** die Öffnung (10) im Glaselement (3) erzeugt wird, indem

   - der Laserstrahl (27) eines Ultrakurzpulslasers (29) auf eine der Seitenflächen (30, 31) des Glaselements (3) gerichtet und mit einer Fokussierungsoptik (23) zu einem langgezogenen Fokus im Glaselement (3) konzentriert wird, wobei durch die eingestrahlte Energie des Laserstrahls (27) eine filamentförmige Schädigung (32) im Volumen des Glaselements (1) erzeugt wird, deren Längsrichtung quer zur Seitenfläche (30, 31), insbesondere senkrecht zur Seitenfläche (30, 31) verläuft und zur Erzeugung einer filamentförmigen Schädigung der Ultrakurzpulslaser (29) einen Puls oder ein Pulspaket mit mindestens zwei aufeinander folgenden Laserpulsen einstrahlt, und wobei nach dem Einfügen der filamentförmigen Schädigung (32)

- das Glaselement (3) einem Ätzmedium ausgesetzt wird, welches Glas des Glaselements (3) mit einer Abtragsrate von kleiner als 8 $\mu$m pro Stunde abträgt

und

- die filamentförmige Schädigung (32) zu einem Kanal (41) aufweitet und
- in der Wandung (54) des Kanals (41) abgerundete, kalottenförmige Vertiefungen (37) einfügt, wobei nebeneinander eine Vielzahl von filamentförmigen Schädigungen (32) eingefügt werden und durch das Ätzen der Durchmesser der Kanäle (41) vorzugsweise so weit vergrößert wird, bis das Glas zwischen den Kanälen (41) abgetragen wird und die Kanäle (41) sich vereinigen.

6. Verfahren gemäß einem der vorstehenden Ansprüche, **dadurch gekennzeichnet, dass**

- der Laserstrahl (27) eines Ultrakurzpulslasers (29) auf eine der Seitenflächen (30, 31) des Glaselements (3) oder Glasteils (5, 7) gerichtet und mit einer Fokussierungsoptik (23) zu einem langgezogenen Fokus im Glas konzentriert wird, wobei durch die eingestrahlte Energie des Laserstrahls (27) filamentförmige Schädigungen 32 im Volumen des Glases erzeugt werden, deren Längsrichtung quer zur Seitenfläche (30, 31) des Glaselements (3) oder Glasteils (5, 7) verläuft und zur Erzeugung einer filamentförmigen Schädigung der Ultrakurzpulslaser (29) einen Puls oder ein Pulspaket mit mindestens zwei aufeinander folgenden Laserpulsen einstrahlt, wobei der Laserstrahl (27) so eingestrahlt wird, dass ein Ende des langgezogenen Fokus innerhalb des Glases liegt, so dass auch die filamentförmige Schädigung (32) im Glas endet, sich aber bis zu einer Seitenfläche (31, 32) erstreckt, und wobei nach dem Einfügen der filamentförmigen Schädigungen 32
- das Glas einem Ätzmedium ausgesetzt wird, welches das Glas des Glaselements 3 mit einer Abtragsrate kleiner als 8 $\mu$m pro Stunde abträgt und
- die filamentförmigen Schädigungen (32) zu einem Kanal (41) aufweitet, so dass aufgrund der im Glas endenden filamentförmigen Schädigungen (32) die Kanäle (41) ebenfalls im Glas enden und einseitig geschlossen sind, wobei sich die Kanäle (41) beim Ätzen seitlich vereinigen, so dass eine Ausnehmung (24) im Glas erzeugt wird.

7. Verfahren gemäß einem der beiden vorstehenden Ansprüche, **gekennzeichnet durch** zumindest eines der Merkmale:

- zwischen den Kanälen (41) werden Grate (52) gebildet, die parallel zur Längsrichtung der Kanäle (41) verlaufen,
- der Klebstoff wird so aufgetragen, dass die Kante (100) der Öffnung (10) klebstoff-frei bleibt,
- die Kanäle (41) werden mit einem basischen Ätzbad, insbesondere mit einem Ätzbad mit einem ph-Wert >12 eingefügt,
- der Klebstoff (12) wird mit einer Dicke von höchstens 50 $\mu$m, bevorzugt höchstens 20 $\mu$m und bevorzugst mindestens 2 $\mu$m appliziert,
- es wird ein lichthärtender, vorzugsweise ein UV-härtender Klebstoff (12) aufgetragen und der Klebstoff (12) durch eines der Glasteile (5, 7) hindurch mit Licht bestrahlt, so dass der Klebstoff (12) aushärtet und das Glasteil (5, 7) fest mit dem Glaselement (3) verklebt, es wird ein Glaselement (3) mit zumindest zwei nebeneinander verlaufenden Öffnungen (10) bereitgestellt, die durch einen Steg (19) voneinander getrennt sind, der eine minimale Breite von höchstens 400 $\mu$m aufweist, wobei der Steg des Glaselements (3) mit Klebstoff mit einem Glasteil (5, 7) verbunden wird.

8. Verfahren gemäß einem der vorstehenden Ansprüche, **dadurch gekennzeichnet, dass** in zumindest einem der Glasteile (5, 7) eine Öffnung (40) vorhanden ist oder in dieses eingefügt wird, wobei das Glasteil (5, 7) so mit dem Glaselement (3) zusammengeführt wird, dass die Öffnung (40) eine Verbindung zur Öffnung (10) im Glaselement (3) und damit eine fluidleitende Verbindung in den beim Verschließen mit den beiden Glasteilen (5, 7) aus der Öffnung (10) im Glaselement (3) erzeugten Hohlraum (9) herstellt.

9. Mikrofluidikzelle (1), insbesondere hergestellt mit einem Verfahren gemäß einem der vorstehenden Ansprüche, mit einem scheibenförmigen Glaselement (3) mit einer Dicke von höchstens 700 Mikrometern, welches zumindest eine Öffnung (10) aufweist, welche die beiden gegenüberliegenden parallelen Seitenflächen (30, 31) des Glaselements (3) verbindet, wobei jede der Seitenflächen (30, 31) des Glaselements (3) mit einem Glasteil (5, 7) verbunden ist, so dass die Öffnung (10) durch die beiden Glasteile (5, 7) verschlossen ist und einen zwischen den beiden Glasteilen (5, 7) eingeschlossenen, für die Führung von Flüssigkeiten geeigneten Hohlraum (9) bildet, wobei das Glaselements mit zumindest einem der beiden Glasteile durch eine Klebstoffschicht verbunden ist, wobei die Klebstoffschicht die zumindest eine Öffnung im Glaselement ausspart..

10. Mikrofluidikzelle (1) gemäß dem vorstehenden Anspruch, **gekennzeichnet durch** zumindest eines der folgenden Merkmale:

- das Glaselement (3) ist mit zumindest einem der Glasteile (5, 7) durch eine Klebstoffschicht (15) verbunden, wobei die Klebstoffschicht (15) einen ausgesparten Bereich (13) um die zumindest eine Öffnung (10) aufweist, so dass der durch das Glasteil (5, 7) gebildete Teil (91) der Wandung des Hohlraums (9) von der Klebstoffschicht (15) ausgespart ist und vorzugsweise durch das Material des Glasteils (5, 7) gebildet wird und wobei die Kante (100) der Öffnung (10) klebstofffrei ist,

- ein Glaselement (2, 3, 4) oder Glasteil (5, 7) weist eine einseitig offene Ausnehmung (24) auf, welche Bestandteil eines mit einer Öffnung (10) im Glaselement (3) gebildeten Hohlraumes (9) ist oder mit dem Hohlraum (9) kommuniziert.

11. Mikrofluidikzelle (1) gemäß dem vorstehenden Anspruch, **dadurch gekennzeichnet, dass** der Teil der Wandung des Hohlraums (9), welcher durch die Kante (100) der Öffnung (10) gebildet wird, kalottenförmige Vertiefungen (37) aufweist.

12. Mikrofluidikzelle (1) gemäß dem vorstehenden Anspruch, **gekennzeichnet, durch** zumindest eines der folgende Merkmale:

- die Tiefe der kalottenförmigen Vertiefungen (37) ist im Mittel kleiner als 5 $\mu$m,
- die Querabmessungen der kalottenförmigen Vertiefungen (37) betragen im Mittel 5 $\mu$m bis 20 $\mu$m
- die Oberfläche der Kante (100) ist durch die Kanäle (41) gegenüber einer glatten Kantenfläche ohne Kanäle (41) um einen Faktor 1,1 bis 1,4 vergrößert.

13. Mikrofluidikzelle (1) gemäß einem der vorstehenden Ansprüche, **dadurch gekennzeichnet, dass** im Glaselement (3) mindestens zwei Öffnungen (10) eingefügt sind, derart, dass der Bereich des Glaselements (3) zwischen den Öffnungen (10) eine Struktur (39) mit mindestens einem Steg (19) bildet, dessen minimale Breite kleiner als 1 mm beträgt, wobei für die Struktur ein Parameter G definiert ist, der gegeben ist durch:

$$G = \frac{l_1^2}{l_2 \cdot b \cdot \sqrt[3]{h} \cdot N},$$

wobei der Parameter G einen Wert von mindestens 10 mm$^{-1/3}$ und von höchstens 400 mm$^{-1/3}$ aufweist, wobei $l_1$ die längste Kantenlänge zwischen zwei entlang der Kante einer der Öffnungen (10) benachbarten Kontaktgebieten (44) und $l_2$ die Länge der kürzest möglichen geradlinigen Verbindung zwischen zwei Kontaktgebieten (44) ist, und wobei ein Kontaktgebiet (44) eines Stegs (19) jeweils als kreisförmiger Bereich des Glaselements (3) mit einem Durchmesser von 1 mm definiert ist, welches so am Steg (19) angeordnet ist, dass deren Rand die Ränder beider Öffnungen (10), deren Zwischenbereich den Steg (19) bildet, an jeweils mindestens einem Punkt berührt, und wobei b die minimale Stegbreite, h die Dicke des Glaselements (3) und N die Anzahl der Kontaktgebiete (44) bezeichnen.

14. Zwischenprodukt zur Herstellung einer Mikrofluidikzelle (1), insbesondere zur Herstellung einer Mikrofluidikzelle gemäß einem der vorstehenden Ansprüche, mit einem scheibenförmigen Glaselement (3) mit einer Dicke von höchstens 700 Mikrometern, welches so strukturiert ist, dass dieses zumindest eine Öffnung (10) aufweist, welche die beiden gegenüberliegenden parallelen Seitenflächen (30, 31) des Glaselements (3) verbindet, wobei jede der beiden Seitenflächen (30, 31) mit einer Klebstoffschicht (15) versehen ist, um die Seitenflächen (30, 31) mit Glasteilen (5, 7) zu verbinden, so dass die Öffnung (10) verschlossen und eine Mikrofluidikzelle (1) mit einem für die Führung von Flüssigkeiten geeigneten Hohlraum (9) gebildet wird, wobei die Klebstoffschicht (15) die zumindest eine Öffnung (10) im Glaselement (3) ausspart.

15. Mikrofluidik-Zelle (1), insbesondere hergestellt mit einem Verfahren gemäß einem der Ansprüche 1 bis 8, welche einen Stapel (234) mit mindestens zwei miteinander verbundenen scheibenförmigen Glaselementen (2, 3, 4) aufweist, sowie zwei Glasteile (5, 7), welche mit dem Stapel (234) verbunden sind und zwischen denen der Stapel (234) angeordnet ist, wobei die Glaselemente (2, 3, 4) jeweils mindestens eine Öffnung (10) aufweisen, welche durch die Verbindung mit angrenzenden Glaselementen (2, 3 ,4) oder Glasteilen (5, 7) verschlossen ist und dadurch einen für die Führung von Flüssigkeiten geeigneten Hohlraum (9) bildet, wobei die Hohlräume (9) in den Glaselementen (2, 3, 4) miteinander kommunizieren und wobei die Glaselemente (2, 3, 4) und Glasteilen 5, 7 miteinander durch Klebstoffschichten (15) verbunden sind, welche die Öffnungen (10) aussparen.

Fig. 1

Fig. 2

Fig. 3

Fig. 4

Fig. 5

Fig. 6

32

3

30

Fig. 7

41

3

30

Fig. 8

10

41

100    101

1

30

Fig. 9

Fig. 16

Fig. 10

Fig. 11

Fig. 12

Fig. 13

Fig 14

Fig 15

Fig. 17

Fig. 18

Fig. 19

Fig. 20

Fig. 21

30

dx    320                    3

30

dy

Fig. 22

30        32   320        3

32

320

31

23

27

Fig. 23

Europäisches
Patentamt

European
Patent Office

Office européen
des brevets

# EUROPÄISCHER RECHERCHENBERICHT

Nummer der Anmeldung

EP 19 16 8017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 088 076 A1 (ASAHI FR R&D CO LTD [JP]) 2. November 2016 (2016-11-02) | 1-4,9, 10,14,15 | INV. B01L3/00 |
| Y | * Absatz [0070] - Absatz [0076]; Abbildung 1 * <br> * Absatz [0081] * <br> * Absatz [0098] - Absatz [0100] * <br> ----- | 5-8, 11-13 | |
| Y | US 2016/199944 A1 (HOSSEINI S ABBAS [US]) 14. Juli 2016 (2016-07-14) * Absatz [0089] - Absatz [0091]; Abbildungen 3 - 3F * ----- | 5-7, 11-13 | |
| Y | DE 699 06 772 T2 (MOTOROLA INC [US]) 11. März 2004 (2004-03-11) * Abbildung 2 * ----- | 8 | |

RECHERCHIERTE
SACHGEBIETE (IPC)

B01L

Der vorliegende Recherchenbericht wurde für alle Patentansprüche erstellt

| Recherchenort | Abschlußdatum der Recherche | Prüfer |
|---|---|---|
| Den Haag | 21. Mai 2019 | Ueberfeld, Jörn |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

.........................................................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 16 8017

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-05-2019

| Im Recherchenbericht angeführtes Patentdokument | Datum der Veröffentlichung | Mitglied(er) der Patentfamilie | Datum der Veröffentlichung |
|---|---|---|---|
| EP 3088076 A1 | 02-11-2016 | CN 105848773 A | 10-08-2016 |
| | | EP 3088076 A1 | 02-11-2016 |
| | | JP 6131338 B2 | 17-05-2017 |
| | | JP WO2015098720 A1 | 23-03-2017 |
| | | US 2016325278 A1 | 10-11-2016 |
| | | WO 2015098720 A1 | 02-07-2015 |
| US 2016199944 A1 | 14-07-2016 | CN 106132627 A | 16-11-2016 |
| | | EP 3102358 A1 | 14-12-2016 |
| | | JP 2018509298 A | 05-04-2018 |
| | | KR 20160117531 A | 10-10-2016 |
| | | US 2016199944 A1 | 14-07-2016 |
| | | WO 2016114934 A1 | 21-07-2016 |
| DE 69906772 T2 | 11-03-2004 | AT 236719 T | 15-04-2003 |
| | | AU 6418499 A | 01-05-2000 |
| | | CA 2346059 A1 | 20-04-2000 |
| | | DE 69906772 T2 | 11-03-2004 |
| | | EP 1123157 A1 | 16-08-2001 |
| | | ES 2197681 T3 | 01-01-2004 |
| | | JP 2002527254 A | 27-08-2002 |
| | | US 6527890 B1 | 04-03-2003 |
| | | US 6544734 B1 | 08-04-2003 |
| | | US 6572830 B1 | 03-06-2003 |
| | | US 2003118481 A1 | 26-06-2003 |
| | | US 2003129646 A1 | 10-07-2003 |
| | | WO 0021659 A1 | 20-04-2000 |

EPO FORM P0461

Für nähere Einzelheiten zu diesem Anhang : siehe Amtsblatt des Europäischen Patentamts, Nr.12/82

**EP 3 560 594 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2719460 B1
- DE 102011085371 A1
- EP 2547618 B1
- JP 2013188677 A
- CN 103992948 B
- EP 3037826 A1
- EP 3088076 A1
- US 2008219890 A
- US 9446378 B
- US 9517929 B